# EUROPEAN PATENT APPLICATION

(11) **EP 4 722 658 A1**
(43) Date of publication of application: **08.04.2026**
(21) Application number: 25203696.7
(22) Date of filing: 22.09.2025
(51) Int. Cl.: G01D 3/08, G01D 5/14

(54) **SENSOR DEVICE WITH DIAGNOSTIC CAPABILITIES, AND METHOD**

(30) Priority: 04.10.2024 EP 24204853
(71) Applicant: Melexis Technologies SA, 2022 Bevaix (CH)
(72) Inventor: Leroy, Sébastien, 2022 Bevaix (CH); Ajbl, Andrea, 2022 Bevaix (CH); Lázár, Zsombor, 2022 Bevaix (CH); Popescu-Stroe, Victor, 2022 Bevaix (CH)
(74) Representative: Jacobs, Lambert

(57) **Abstract**

A sensor device (300) comprising: a first set of nodes connectable to a first set of sensors (310), a forward signal path (323) comprising: an analog circuit (ASP, 311) comprising at least one amplifier; a digitizer circuit (312) for providing digital values (dv); a digital processing circuit (DSP, 313); a digital-to-analog conversion circuit (317) for generating analog test signals (ats) based on digital test values (dtv) provided by a diagnostic controller (316); a multiplexer (318) for selectively routing signals (ss1) from the first set of input nodes to the ASP (311) in a first mode, and for routing the analog test signal (ats) to the ASP (311) in a second mode; the DSP being configured to analyse the digital values (dv) and/or to determine an angle or a phase. The sensor device may further comprise a second set of nodes connectable to a second set of sensors, and/or said sensors.

## Description

### Field of the invention

The present invention relates in general to the field of sensors, and more in particular to sensor devices (e.g. sensor chips) having diagnostic capabilities, e.g. self-diagnostics or self-test capabilities, and to methods of detecting an error of such a sensor device.

### Background of the invention

Electronic components are being heavily used in automotive applications, not only for entertainment purposes (such as e.g. music), or assistance functions (such as e.g. electric mirror, or parking assistance), electronic sensors are also being used for steering assistance, engine control, and other safety-related functions. Evidently, the requirements in terms of reliability and system availability for such functions continues to increase, and safety standards (such as e.g. the SIL standard) are being developed, while at the same time pressure on costs remains high.

In order to meet safety standards, such as for example ASIL standards ("Automotive safety integrity level") or other safety standards in the automotive field, it is desired to implement and use corresponding self-tests, including built-in self-tests, not only at start-up but also during normal operation, as well as automatic monitoring structures or corresponding redundant functional blocks and/or signal paths.

Conventional sensor systems, in particular magnetic sensor systems, use a single-channel analog main signal path. Other conventional solutions use two identical sensors and processing paths to meet ASIL requirements.

US2012074972 discloses a monolithic integrated circuit sensor system comprising a first sensor device having a first signal path for a first sensor signal on a semiconductor chip; and a second sensor device having a second signal path for a second sensor signal on the semiconductor chip, the second signal path being distinct from the first signal path, wherein a comparison of the signal from the first signal path and the signal from the second signal path provides a sensor system self-test.

There is always room for improvements or alternatives.

### Summary of the invention

It is an object of the present invention to provide a sensor system and a sensor device with diagnostic capabilities, e.g. with a self-diagnostic function. It is also an object of the present invention to provide a method of detecting an error of such a sensor device or such a sensor system.

It is an object of particular embodiments of the present invention to provide such a system or device that is capable of detecting a fault condition during normal operation of the device.

It is an object of particular embodiments of the present invention to provide such a system or device that is also capable of reporting the detected fault condition, e.g. to another processor (e.g. to an electronic control unit, ECU).

These and other objectives are accomplished by a method and circuit according to embodiments of the present invention.

According to a first aspect, the present invention provides a sensor device (e.g. a packaged chip, a semiconductor substrate) comprising: a first set of at least two input nodes connectable to a first set of at least two sensors or transducers for receiving a first set of at least two sensor signals (e.g. ss1) (e.g. voltage signals or current signals) indicative of a position (e.g. a linear or an angular position) or a phase (e.g. θ1) (e.g. of an external object such as a magnet or a target) to be measured; a first forward signal path comprising: an analog circuit (e.g. ASP) comprising at least one amplifier configured for amplifying a set of at least two analog signals or signals derived therefrom (e.g. a sum of two or three sensor signals, or a difference between two sensor signals) and for providing a set of at least two amplified signals (e.g. as); a digitizer circuit (e.g. ADC) configured for digitizing the set of at least two amplified signals (e.g. as), and for providing a set of at least two digital values (e.g. dv); a digital processing circuit (e.g. DSP) configured for determining a position or phase (e.g. θ1) based on the set of at least two digital values (e.g. dv); a test signal generation circuit for generating a set of at least two analog test signals (e.g. ats); a routing circuit (e.g. comprising an analog multiplexer and/or a plurality of switches or tri-state buffers or the like) for selectively routing the first set of sensor signals (e.g. ss1) from the first set of input nodes to the analog circuit in a first routing mode, and for selectively routing the set of analog test signals (e.g. ats) obtained from the test signal generation circuit to the analog circuit in a second routing mode; wherein the sensor device is configurable in a first mode of operation wherein the routing circuit is configured in the first routing mode, and the digital processing circuit (e.g. DSP) is configured to determine said position or phase (e.g. θ1) based on the first set of sensor signals (e.g. ss1); and wherein the sensor device is configurable in a second mode of operation wherein the routing circuit is configured in the second routing mode, and the digital processing circuit (e.g. DSP) is configured to analyse and/or verify the set of digital values (e.g. dv) derived from the set of analog test signals (ats) and/or to determine a test position or test phase (e.g. θ2) derived from the set of analog test signals (e.g. ats), e.g. for allowing error detection.

In an embodiment, the error detection is based on a consistency test between the set of digital values (dv) provided by the digitizer circuit on the one hand, and the digital test values (dtv) provided by the diagnostic controller on the other hand. Several consistency tests are contemplated, for example: (i) The consistency test may be based on a comparison of the individual values of dv and dtv (e.g. by mutually comparing the sine values, and by mutually comparing the cosine values). In order for this test to work, the amplifier gain of the ASP may be set to a predefined gain, and/or the diagnostic controller may scale the digital test values depending on the amplifier gain, (ii) The consistency test may also be based on a comparison of a ratio of the dv-values, and a ratio of the dtv-values, (iii) the consistency test may also be based on a comparison of normalized dv-values, and normalized dtv values, where the normalized dv-values may be obtained by dividing the individual dv-values by a sum of squares of the dv-values, and where the normalized dtv-values may be obtained by dividing the individual dtv-values by a sum of squares of the dtv-values. Of course, if the dtv-values were already normalized, this step can be omitted.

In an embodiment, the error detection is based on a consistency test between an angular value (e.g. θ2) derived from the set of digital values (e.g. dv) provided by the digitizer circuit and derived from the analog test signals atv on the one hand, and a known angular value related to the digital test values (e.g. dtv) on the other hand.

The (first) analog circuit (e.g. ASP) may comprise one or more amplifiers, e.g. two amplifiers capable of operating in parallel, or a single amplifier used in a time-multiplexed manner.

The (first) digitizer circuit (e.g. ADC) may comprise one or more analog-to-digital convertors (e.g. ADC), e.g. two ADC's capable of operating in parallel, or a single ADC used in a time-multiplexed manner.

The (first) digital-to-analog conversion circuit may comprise a single digital-to-analog convertor (e.g. DAC), or may comprise two or more DACs. The digital-to-analog-conversion circuit may be or may comprise a pulse-width-modulation (PWM) circuit followed by a low-pass-filter; or may be or may comprise a Weighted Resistor DAC (which uses binary-weighted resistors to create an output); or may be or may comprise a so called "R-2R Ladder DAC" (which uses only two resistor values to form a ladder network); or may be or may comprise a "Sigma-delta DAC" or a "Delta-Sigma DAC" (which uses oversampling and noise shaping); or may be or may comprise a "Switch-Capacitor DAC" (which uses capacitors rather than resistors to build the conversion network).

The DSP may be configured (inter alia) for determining a ratio of two digital values, and for determining said output value (e.g. phase or angle) as a predefined function of said ratio.

The ASP may comprise multiple cascaded amplification stages. Even though, during production, each amplifier stage is typically trimmed separately for gain and/or offset control, an underlying idea of the present invention is to evaluate the forward data path "as a whole". In addition, the forward data path processes at least two input signals. The previous paragraphs do not mean that the sensor device is prohibited from having e.g. a further mode of operation, where other test signals are injected at intermediate positions in the forward data-path, e.g. between the ASP and the ADC, or between the ADC and the DSP.

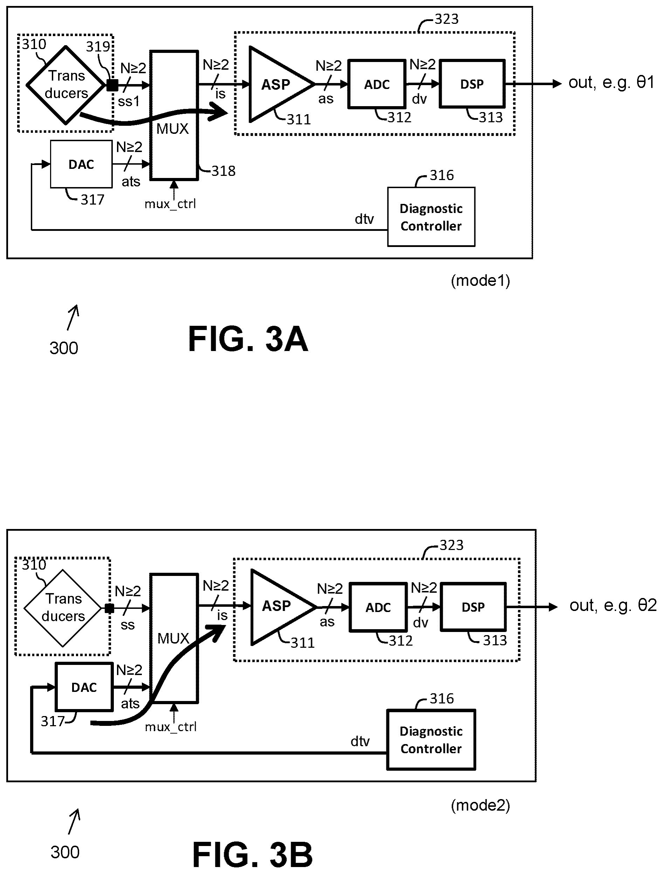

An example of such a sensor device is illustrated in FIG. 3A (first mode) and FIG. 3B (second mode). The "first mode" can also be referred to as the "normal operation mode" of the sensor device. The second mode can also be referred to as the "test mode" or evaluation mode" or "diagnostic mode".

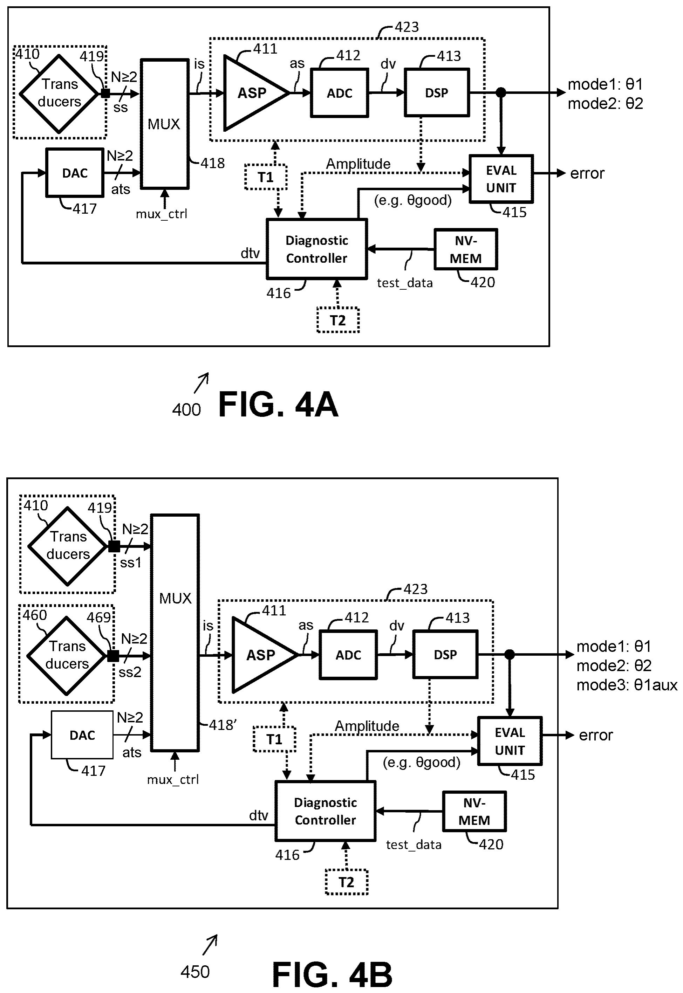

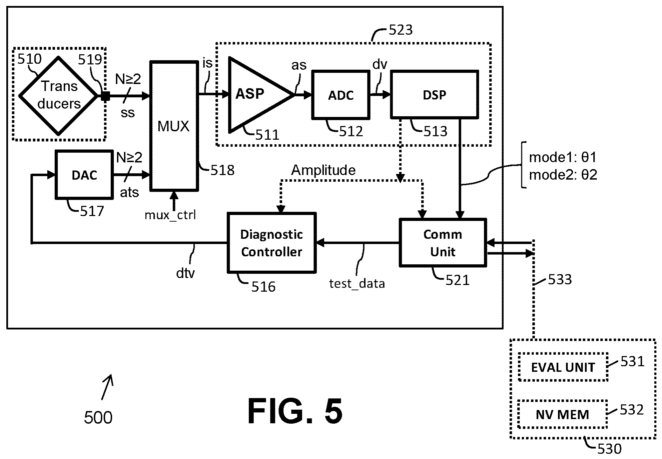

The "actual error detection" can be performed entirely inside the sensor device itself (e.g. as illustrated in FIG. 4A), or entirely outside (e.g. as illustrated in FIG. 5), or partially inside and partially outside.

The sensor device may have a (first) output port for providing the physical quantity (e.g. said position or said phase), e.g. to an external processor, or the first output value may be provided to an external processor via a communication unit or interface unit.

Preferably the DSP is a programmable digital processor, capable of executing computer-readable instructions (also known as "software or firmware"). The DSP may be an ASIL-D compliant DSP.

In an embodiment, the "sensor device" is a semiconductor die, e.g. a CMOS substrate comprising said forward signal path, said DAC circuit, said diagnostic controller, and said routing circuit. The semiconductor device may further comprise at least two sensors (e.g. two or more magnetic sensors), embedded in the semiconductor substrate.

In an embodiment, the "sensor device" is a packaged semiconductor device comprising said semiconductor die. The packaged semiconductor device may comprise at least one semiconductor substrate overmoulded by a plastic or a ceramic moulding compound. The packaged device may further comprise at least two sensors (e.g. two or more magnetic sensors) implemented on another semiconductor die, but also packaged in the same semiconductor device.

In an embodiment, the "sensor device" is an assembly comprising: a printed circuit board (PCB) with a plurality of coils (acting as magnetic sensors), and a packaged semiconductor device mounted on the PCB. The packaged sensor device may comprise said semiconductor substrate, and be electrically connected to said coils via pins or "elongated leads" of the package.

The semiconductor die may be incorporated in the sensor device, and the sensors may be embedded also in said semiconductor substrate, but that is not absolutely required, and it suffices that the sensors are electrically connected to said semiconductor substrate.

In an embodiment, the "sensor device" is a semiconductor substrate, e.g. a CMOS substrate comprising said forward signal path, said DAC circuit, said diagnostic controller, said routing circuit, and also said sensors or transducers.

As far as is known to the inventors, existing sensor device do not allow to test the "forward signal path" in this manner, more specifically, by generating, in a test-mode at least two analog signals, and applying them together to the analog signal block (ASP), and processing these signals in the same way as the measured signals, e.g. using the same trimming parameters, and/or using the same gain and/or offset control of the amplifier(s), and/or using the same gain and/or offset of the at least one ADC. Preferably the only difference between an "actual measurement" (in the first mode) and a "test measurement" (in the second mode) is the routing of either the sensor signals, or the analog test signals as input signals to the "forward signal path".

In an embodiment, the sensor device is a magnetic position sensor device, e.g. a linear position sensor, or an angular position sensor, and the set of sensors or transducers are magnetic sensors (e.g. horizontal Hall elements, vertical Hall elements, magneto-resistive elements) or coils (e.g. coils wound on a printed circuit board, or coils formed in the "interconnection stack" of a CMOS device, or combinations hereof.

In an embodiment, the sensor device is an angular position sensor device, for determining an angular position of a two-pole magnet which is rotatable about a rotation axis, or for determining an angular position of a four-pole magnet which is rotatable about a rotation axis, as part of an angular position sensor system.

In an embodiment, the sensor device is a linear position sensor device, for determining a linear position of the sensor device relative to a magnetic structure comprising a plurality of alternating magnetic poles. The linear position may be derived from an angular value θ1, in known manners, e.g. using a linear transformation, taking into account the pole pitch.

In an embodiment, the sensor device is an angular position sensor device, for determining an angular position of a metal or conductive target relative to a plurality of coils, as part of an inductive angular position sensor system.

In an embodiment, the test signal generation circuit comprises: a digital-to-analog conversion circuit for converting a set of at least two digital test values (dtv) into a set of at least two analog test signals (e.g. ats), and a diagnostic controller configured for providing a set of at least two digital test values (e.g. dtv) to the digital-to-analog conversion circuit.

In an embodiment, the DSP of the "first forward signal path" is configured for determining (inter alia) an arctangent function of a ratio of two digital values dv, and the diagnostic controller is configured for determining a sine function and a cosine function, and optionally also a scaling function.

It is noted that the diagnostic controller may be implemented as a single hardware block, or may comprise more than one hardware block, or may be a single software module running on the DSP of the "first forward data path", or may comprise multiple software modules running on the DSP, or a combination of hardware and software blocks.

In an embodiment, the digital-to-analog conversion circuit comprises a DAC with an accuracy of at least 8 bits, or at least 10 bits. In another embodiment, the digital-to-analog conversion circuit comprises a DAC with an accuracy of at most 4 bits or at most 3 bits.

Preferably the diagnostic controller is configured to assign at least two different values (over time) to each of the at least two digital test values. In other words, preferably, none of the at least two digital test values is a constant value, but will change over time.

In an embodiment, the test signal generation circuit is configured for providing the set of at least two analog test signals (e.g. ats) based on a position value or phase value (e.g. θgood1) provided by the digital processing circuit as the result of a previous evaluation.

In an embodiment, the test signal generation circuit is configured for providing the set of at least two analog test signals (e.g. ats) based on a position value or phase value (e.g. θgood2) retrieved from a non-volatile memory (e.g. flash).

In an embodiment, the test signal generation circuit is configured for providing the set of at least two analog test signals (e.g. ats) based on a position value or phase value (e.g. θgood3) obtained from an external processor.

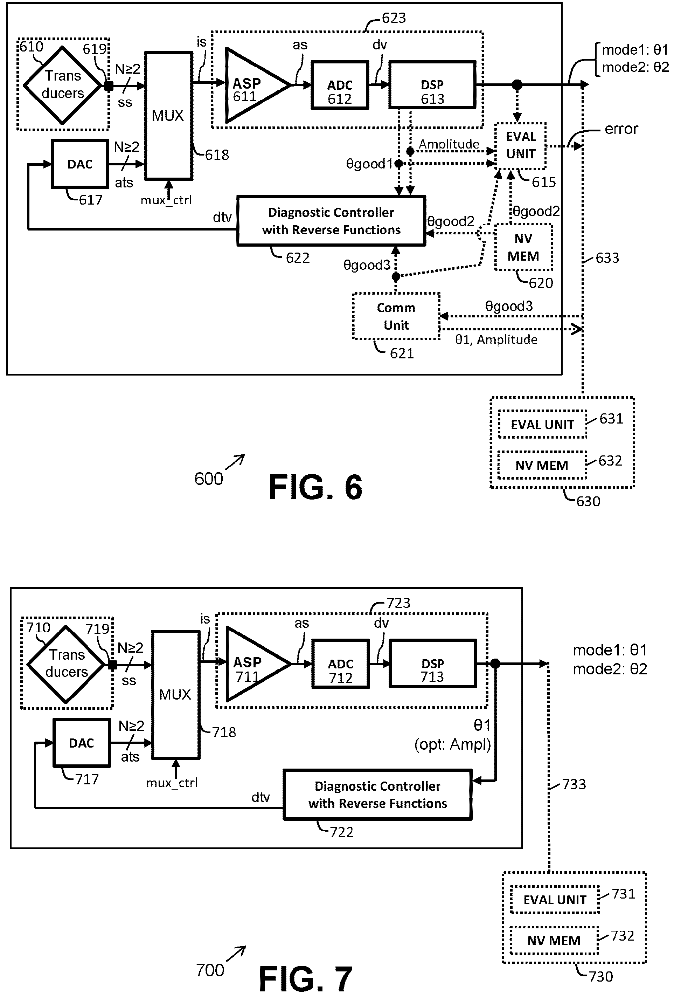

In an embodiment, the diagnostic controller is configured for providing the set of at least two digital test values (e.g. dtv) based on a position value (e.g. a linear or angular position) or phase value (e.g. θgood1) provided by the DSP as the result of a previous evaluation (e.g. in the first mode mode of operation, or in the second mode of operation), e.g. as illustrated in FIG. 7. Using the value of θ1 derived from sensor signals (obtained in mode 1) as a "known good" angle for a subsequent test (to be performed in mode 2), is also referred to herein as "loop-back".

In an embodiment, the diagnostic controller is configured for providing the set of at least two digital test values (e.g. dtv) based on a position value (e.g. linear or angular position) or phase value (e.g. θgood2) retrieved from a non-volatile memory, e.g. as illustrated in FIG. 6.

In an embodiment, the diagnostic controller is configured for providing the set of at least two digital test values (e.g. dtv) based on position value (e.g. linear or angular position) or phase value (e.g. θgood3) obtained from an external processor (e.g. ECU), e.g. as illustrated in FIG. 6.

In an embodiment, the test signal generation circuit is configured for receiving or retrieving an angle value or a phase value; and generating the set of at least two analog test signals (e.g. ats) comprises converting this received or retrieved angle or phase value into one of the following sets of values: a) into at least a sine value and a cosine value of that angle; or b) into at least three 120° phase shifted sine values of that angle.

In an embodiment, the diagnostic controller is configured for receiving or retrieving an angle value or a phase value (e.g. θgood1 from a previous evaluation of the DSP, e.g. θgood2 retrieved from a non-volatile memory, e.g. θgood3 obtained from an external processor), and for converting this angle or phase value into one of the following sets of values: (a) into a sine value and a cosine value of that angle, e.g. in accordance with the formulas A*sin(α), A*cos(α ); or (b) into three 120° phase shifted sine values of that angle, e.g. in accordance with the formulas A*sin(α), A*sin(α+120°), A*sin(α+240°), or (c) into four 90° phase shifted sine values of that angle, e.g. in accordance with the following formulas A*sin(α), A*cos(α ), -A*sin(α), -A*cos(α); wherein A is a scaling factor, or in accordance with the following formulas: A*sin(α), A*sin(α+90°), A*sin(α+180°), A*sin(α+270°).

The scaling factor may be a predefined value, (e.g. hardcoded or stored in a non-volatile memory), or may be provided by an external processor (e.g. an ECU) connected to the sensor device, or may be the same or substantially the same as an amplitude of the digital signals provided by the ADC in a previous execution of the forward data path, e.g. a preceding measurement (mode 1) or a previous evaluation (mode 2).

In an embodiment, the sensor device comprises a non-volatile memory storing at least one of: a customer scaling factor and a customer offset value; and the digital processing circuit (DSP) is configured for determining the position or phase (e.g. θ1) by multiplication with this customer scaling factor and/or by adding said customer offset value after applying said function; and the diagnostic controller is configured for retrieving the same customer scaling factor and the same customer offset value from said non-volatile memory, and for dividing the test-position or test-phase by said customer scaling factor and/or for subtracting the customer offset value from said test-position or test-phase, before converting the position or phase value into sine values.

In an embodiment, the first set of sensors (and if present, optionally also the second set of sensors) is configured for providing two sinusoidal signals having substantially the same amplitude but substantially 90° phase shifted, and wherein the diagnostic controller is configured for providing a set of two digital test values (e.g. dtv) corresponding to a sine and a cosine value of a certain phase;

In an illustrative embodiment, the sensor device comprises two Horizontal Hall elements, embedded in the semiconductor substrate, and arranged on a circle, angularly spaced by 90°.

In another illustrative embodiment, the sensor device comprises two vertical Hall elements, embedded in the semiconductor substrate, arranged such that their axes of maximum sensitivity are perpendicular to each other.

In an embodiment, the first set of sensors (and if present, optionally also the second set of sensors) is configured for providing three sinusoidal signals having substantially the same amplitude but substantially 120° phase shifted, and wherein the diagnostic controller is configured for providing a set of three digital test values (e.g. dtv) corresponding to three sine values of a certain phase, shifted by multiples of 120°.

In an illustrative embodiment, the sensor device comprises three Horizontal Hall elements, embedded in the semiconductor substrate, and arranged on a circle, angularly spaced by multiples of 120°. The sensor device may be further configured to perform a Clarke transformation in the analog domain or in the digital domain to convert the three signals into two 90° phase shifted signals, which can then be divided.

In another illustrative embodiment, the sensor device comprises three vertical Hall elements, embedded in the semiconductor substrate, arranged such that their axes of maximum sensitivity define an angle of 120° or 240° relative to one another.

In an embodiment, the first set of sensors (and if present, optionally also the second set of sensors) is configured for providing four sinusoidal signals having substantially the same amplitude but substantially 90° phase shifted, and wherein the diagnostic controller is configured for providing a set of four digital test values, corresponding to four sine values of a certain phase, shifted by multiples of 90°.

The sensor device may be further configured to subtract diametrically opposite signals to convert the four component signals into two 90° phase shifted difference signals (or gradient signals), e.g. prior to entering the "forward data path". The sensor device may comprise four magnetic sensors, geometrically arranged for providing such four sinusoidal signals, e.g. four Horizontal Hall elements arranged on a circle, angularly spaced by multiples of 90°.

In an embodiment, the set of sensors comprises a plurality of coils (e.g. two coils or three coils or four coils), connected to the semiconductor substrate that contains (inter alia) the forward signal path.

In an embodiment, the sensor device or an external controller connected to the sensor device is configured for detecting an error by performing a consistency test between the second position or phase (e.g. θ2) provided by the forward data path operating in the second mode based on the set of at least two analog test signals (e.g. ats) provided by the digital-to-analog conversion circuit and a corresponding known position or phase (e.g. θgood).

The consistency test may be based on testing whether or not the known good phase or angle θgood that corresponds to the digital test values "dtv" provided to the DAC-circuit, matches the angle (θ2) determined by the forward data path operating in the second mode of operation, within a tolerance margin (e.g. a predefined tolerance margin).

In an embodiment, the consistency test comprises: testing whether a difference (e.g. Δθ) between the second angle (e.g. θ2) and the known good angle (e.g. θgood) lies in a predefined tolerance range, e.g. in the range from -2.0° to +2.0°, or in the range from -1.5° to +1.5°, or in the range from -1.0° to +1.0°,. or in the range from -0.75° to +0.75°, or in the range from -0.5° to +0.5°, or in the range from - 0.25° to +0.25°, or in the range from -0.15° to +0.15°.

In an embodiment, the consistency test comprises: testing whether a difference (e.g. Δθ) between the second angle (e.g. θ2) and the known good angle (e.g. θgood) lies in an adaptable tolerance range which depends on the amplitude of the set of at least two analog test signals (e.g. ats) generated by the digital-to-analog convertor circuit.

In this embodiment, one out of at least two tolerance margins can be used, e.g. a relatively large tolerance margin (e.g. ±2.0° deviation) when the amplitude of the analog test signals (e.g. ats) is relatively small (e.g. smaller than a predefined threshold), or a relatively small tolerance margin (e.g. ±0.5°) can be used when the amplitude of the analog test signals (e.g. ats) is relatively large. The rationale behind this embodiment is that, as the analog signals provided by the DAC-circuit are smaller, the signal-to-noise ratio (SNR) of these signals is smaller, and as a consequence the amplified signals will be less accurate, and thus also the resulting digital values (e.g. dtv) will be less accurate, and values derived therefrom, e.g. a ratio, and an arctangent of that ratio. Adapting the tolerance margin of the consistency test to the SNR of the analog signals generated by the DACs, allows a more stringent test of the forward data path.

In an embodiment, the sensor device further comprises a non-volatile memory (e.g. flash) storing at least one set of digital values (test_data), each set comprising a known position or phase (e.g. θgood) and at least two digital values (e.g. a sine and a cosine value thereof) corresponding to that test position or test phase (e.g. θgood), e.g. for allowing said error detection; and wherein the sensor device further comprises an evaluation unit configured for testing a consistency between test position or test phase value (e.g. θ2) derived from the at least two digital test values in the second mode of operation, and the corresponding known test position or phase (e.g. θgood) obtained from the non-volatile memory.

An example of this embodiment is illustrated in FIG. 4A. The sensor device may have a second output port for providing a result of the consistency test, e.g. in the form of an error signal or a validity signal.

In an embodiment, the NV-memory may comprise a list of sets of three corresponding values, each set comprising for example: an angle, a sine of that angle, and a cosine of that angle. The diagnostic controller can read e.g. the sine and cosine value from the list, optionally apply a predefined (e.g. hardcoded) scaling factor, and apply the scaled values to the DAC-circuit.

In an embodiment, the NV-memory comprises a list of sets of at least four corresponding values, each set comprising for example: an angle, K1 times a sine of that angle, K1 times a cosine of that angle, a tolerance margin TM1 corresponding to the scaling factor K1).

In an embodiment, the sensor device further comprises a communication unit configured to receive information (e.g. data values, or an index-value to a table) from which said at least two digital test values (e.g. dtv) to be applied to the DAC-circuit can be derived; and wherein the sensor device is configured for outputting the test position or test value (e.g. θ2) derived from the at least two digital test values (e.g. dtv) in the second mode of operation, e.g. for allowing the external processor to perform a consistency test.

An example of this embodiment is illustrated in FIG. 5. The test quantity (e.g. test angle) may be provided on the same output port as the port used to output the physical quantity to be measured by the sensors (e.g. θ1). In a variant (not shown), the DSP has two different output ports, including a first output for providing the measured angle or phase values θ1, and a second output for providing the test values θ2.

In an embodiment, the sensor device comprises a non-volatile memory storing a list with sine and cosine values, and the external processor has a non-volatile memory storing a list with corresponding angle values, and the external processor (e.g. ECU) is configured to provide an index to the sensor device, and the sensor device is configured to obtain the corresponding sine and cosine values from the list, and apply them as digital test values to the DAC-circuit, optionally after scaling them, and the external processor is configured for performing a consistency between the resulting angle θ2, and an angle (θgood) obtained from the list stored in the external processor using that same index.

In an embodiment, the analog circuit (e.g. ASP1) comprises at least two amplifiers stages connected in series.

During production of the sensor device, each amplifier stage may be individually trimmed for gain and/or offset correction, in manners known in the art. When operating in the "first mode" and the "second mode" as specified above, however, the at least two amplifier stages operate in a combined manner (e.g. as one big amplifier).

In an embodiment, the sensor device comprises a first set of sensors, and a second set of sensors, and the first set of sensors comprises a first number (e.g. N1) of sensor elements, and the second set of sensors comprises a second number (e.g. N2) of sensor elements equal to the first number.

In an embodiment, the first set of sensors and the second set of sensors are two distinct sensor arrangements, each comprising separate sensor elements. The first set of sensors and the second set of sensors may be arranged for measuring substantially the same angle or phase (e.g. within a predefined tolerance margin smaller than e.g. ±2°, or smaller than ±1°). In a variant, the first set of sensors is arranged for measuring a first phase or angle, and the second set of sensors is arranged for measuring a second phase or angle, having a predefined offset from the first phase or angle (e.g. in the range from 15° to 65°, e.g. equal to about 30°, or equal to about 45°, or equal to about 60°).

In an embodiment, the sensor device comprises a first set of sensors, and a second set of sensors, and the first set of sensors comprises a first number (e.g. N1) of sensor elements, and the second set of sensors comprises a second number (e.g. N2) of sensor elements different from the first number.

In an embodiment, the sensor device is configured to produce the position or phase of the movable object uniquely based (or based only) on said at least two digital values provided by the digitizer circuit of the first forward signal path.

In an embodiment, in the second mode of operation, the routing circuit is further configured to disconnect (e.g. entirely disconnect) said first set of at least two input nodes, (e.g. from the first forward signal path).

In an embodiment, the sensor device further comprises a second set of at least two nodes connectable to a second set of sensors for receiving a second set of at least two sensor signals (e.g. ss2) indicative of said position or phase to be measured; and wherein the routing circuit is further configured for selectively routing the second set of sensor signals (e.g. ss2) from the second set of input nodes to the analog circuit of the first forward signal path in a third routing mode; and wherein the sensor device is further configurable in a third mode of operation wherein the routing circuit is configured in the third routing mode, and the digital processing circuit (e.g. DSP) is configured to analyse and/or verify the set of digital values (e.g. dv) derived from the second set of sensor signals (e.g. ss2) and/or to determine an auxiliary position or an auxiliary phase (e.g. θ1aux) derived from the second set of sensor signals (e.g. ss2).

In this embodiment, the error detection may be based on a comparison of the angle or phase value θ1 (also referred to herein as the "main angle") derived from the first set of sensor signals ss1, and the auxiliary angle θ1aux (also referred to herein as the "auxiliary angle") derived from the second set of sensor signals ss2.

In an embodiment, the first set of sensors and the second set of sensors are arranged or configured such that the "main angle" and the "auxiliary angle" are substantially equal (e.g. within a predefined tolerance margin), in the absense of errors.

In another embodiment, the first set of sensors and the second set of sensors are aranged or configured such that a difference between the "main angle" and the "auxiliary angle" is substantially equal (e.g. within a predefined tolerance margin) to a predefined constant, in the absense of errors. The predefined constant may e.g. by 45° or 30° or 60°. This predefined constant may be stored in a non-volatile memory. The DSP may optionally be configured to add or to subtract this constant when calculating the auxiliary angle or phase.

In an embodiment, the first set of sensors and the second set of sensors are both configured to measured magnetic field components.

In an embodiment, the first set of sensors is configured to measure two magnetic field components (e.g. Bx and By), and the second set of sensors is configured to measure four magnetic field components (e.g. Bz) and to provide four values (Bz1, Bz2, Bz3, Bz4) or to provide two magnetic field differences or gradients of diametrically opposite sensors.

In an embodiment, the first set of sensors and the second set of sensors are of the same type, e.g. both comprising Hall sensors.

In an embodiment, the first set of sensors and the second set of sensors are of a different type, e.g. the first set of sensors are Hall sensors, and the second set of sensors are coils.

In an embodiment, the sensor device comprises only one forward signal path comprising said analog circuit (ASP1), followed by said digital-to-analog convertor (DAC), followed by said digital processing circuit (DSP1).

The sensor device may comprise or may further comprises an evaluation unit configured for testing a consistency between the angle or phase value (e.g. θ1) derived from the first set of sensor signals (e.g. ss1) and the angle or phase value (e.g. θ1aux) derived from the second set of sensor signals (e.g. ss2), optionally taking into account a predefined constant (e.g. if the second set of sensor elements is geometrically shifted or rotated relative to the first set of sensors). Alternatively, this consistency test may be performed by an external processor, e.g. an ECU.

In an embodiment, the sensor device is further configured to calculate or estimate an angular speed (e.g. as a time derivative of the main angle), and the evaluation unit is further configured to perform the consistency test taking into account a time difference ΔT between the moment of evaluation of the first set of sensor signals ss1 and the moment of evaluation of the second set of sensor signals ss2 and the estimated angular speed. Alternatively, this consistency test may be performed by an external processor, e.g. an ECU. The time difference may be a predefined constant which is stored in a non-volatile memory of the sensor device or of the ECU. The angular speed can be calculated by the sensor device, or by the ECU.

The digital signal processor of the first forward signal path may be an ASIL-D compliant DSP.

In an embodiment, the sensor device, in the second and/or third mode of operation, is further configured or configurable to (i) perform a consistency test based on said set of digital values (e.g. dv) and/or based on said test position or test phase (e.g. θgood) and/or based on said auxiliary position or auxiliary phase (e.g. θ1aux), e.g. for allowing error detection. The sensor device may be further configured to output an error signal.

In an embodiment, the sensor device, in the second and/or third mode of operation, is further configured or configurable to (ii) output said set of digital values (e.g. dv) and/or said test position or test phase (e.g. θgood) and/or said auxiliary position or auxiliary phase (e.g. θ1aux), for allowing an external processor to perform a consistency test, e.g. for error detection and/or for error correction.

In an embodiment, the sensor device further comprises: a second set of at least two nodes connectable to a second set of at least two sensors or transducers for receiving a second set of at least two sensor signals (e.g. ss2) indicative of said position or phase to be measured; a second forward signal path comprising: a second analog circuit (e.g. ASP2) comprising at least one amplifier configured for amplifying the two second sensor signals (e.g. ss2) or signals derived therefrom (e.g. a sum of two sensor signals, or a difference between two sensor signals); a second digitizer circuit (e.g. ADC2) for digitizing the amplified second sensor signals, and for providing at least two second digital values (e.g. dv2); a second digital processing circuit (e.g. DSP2) configured for determining a third position or phase (e.g. θ3) based on said at least two (first) digital signals (dv2).

In an embodiment, the first and second DSP is configured for (inter alia) calculating a ratio of two digital values, and for determining a phase value or an angle value as a function (e.g. as an arctangent function) of that ratio.

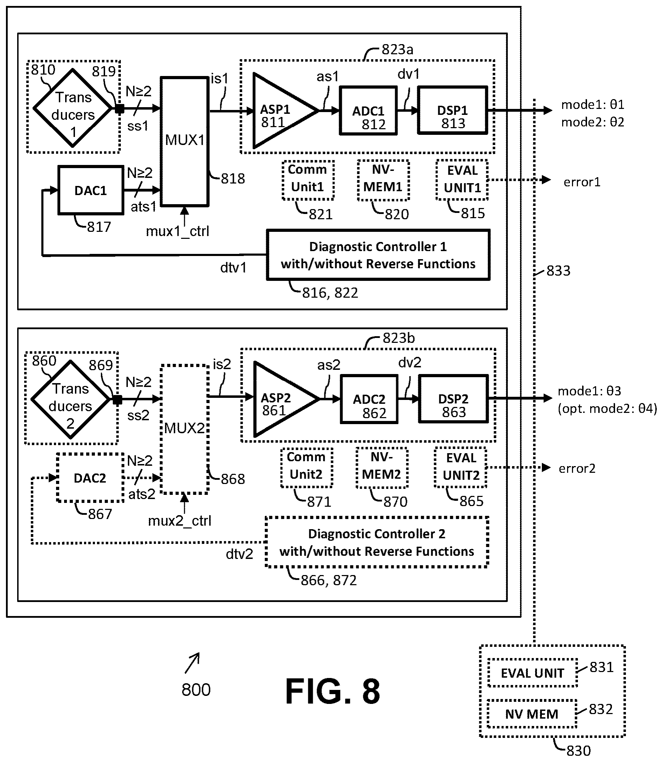

An example of this embodiment is illustrated in FIG. 8, assuming that MUX2, DAC2 and Diagnostic Controller2 are omitted, and that the second sensor signals ss2 are always applied to the input of ASP2.

Preferably the second set of sensors comprises sensor elements of the same type as the first set of sensors (e.g. both sets having magnetic sensor elements in the form of horizontal Hall elements, or both sets having magnetic sensor elements in the form of vertical Hall elements, or both sets having magnetic sensor elements in the form of magneto-resistive (MR) elements).

In an embodiment, only the first forward signal path 823a can selectively be operated in a (first) measurement mode and a (second) diagnostic mode, but the second forward signal path 823b can only be operated in the first mode (measurement mode).

In an embodiment, the sensor device further comprises a second digital-to-analog conversion circuit for generating a second set of at least two analog test signals (e.g. ats2); and wherein the sensor device further comprises a second diagnostic controller, or wherein the first diagnostic controller is further configured for providing at least two digital test values (e.g. dtv2) to the second digital-to-analog conversion circuit; and wherein the sensor device further comprises a second routing circuit (wherein MUX2) or wherein the first routing circuit (e.g. MUX1) is further configurable for selectively routing the second sensor signals (e.g. ss2) from the second set of nodes to the second analog circuit (e.g. ASP2), and for routing the second analog test signals (e.g. ats2) from the second digital-to-analog conversion circuit (e.g. DAC2) to the second analog circuit (e.g. ASP2); wherein the sensor device is configurable (or is configured at a third moment in time) in a third mode of operation for determining a position or a phase (e.g. θ3) by routing the second set of sensor signals (e.g. ss2) to the second analog circuit (e.g. ASP2); and wherein the sensor device is configurable (or is configured at a fourth moment in time) in a fourth mode of operation for determining a second test position or a second test phase (e.g. θ4) by routing the second analog test signals (e.g. ats2) to the second analog circuit (e.g. ASP2), e.g. for allowing error detection.

An example of this embodiment is illustrated in FIG. 8, wherein the blocks DAC2, MUX2, and Diagnostic Controller2 are present.

The components of the first forward signal path and the components of the second forward signal path may be implemented in a single semiconductor substrate. The first set of sensors or transducers and the second set of sensors or transducers may also be implemented (e.g. embedded) in this single semiconductor substrate, although that is not absolutely required, and it suffices that they are electrically connected thereto.

In an embodiment, this semiconductor substrate is a CMOS substrate.

In an embodiment, the first digital processor (e.g. DSP1) and the second digital processor (e.g. DSP2) are implemented on a single digital signal processor (DSP).

In an embodiment, the first DSP (e.g. DSP1) is an ASIL-D compliant DSP.

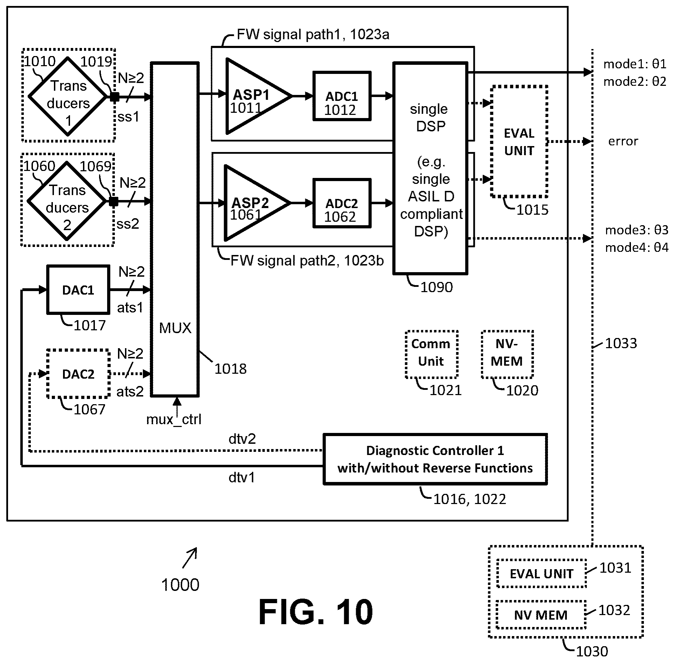

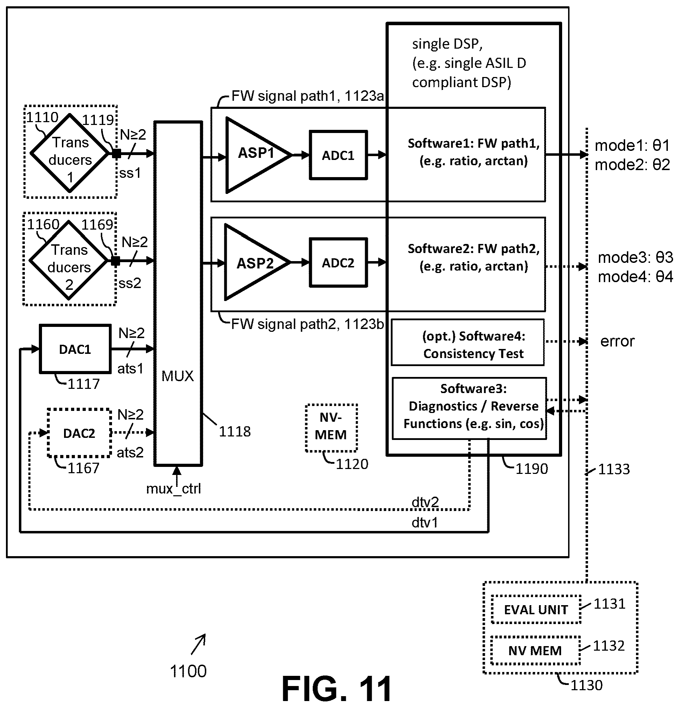

Examples of this embodiment are shown in FIG. 10 and FIG. 11. The functionality of DSP1 may be implemented in a first software module, and the functionality of DSP2 may be implemented in a second software module, non-overlapping with the first software module.

Optionally the first DSP or the single DSP may also comprise one or more further software module(s) for performing the above mentioned consistency test(s), and for providing an output signal (e.g. an error signal) based on the result of the consistency test. In this case, a separate "evaluation unit" is not required.

Optionally the first DSP or the single DSP may also comprise one or more further software module(s) offering the functionality as the diagnostic controller with or without the reverse function, described above. In this case, a separate "diagnostic controller" or a separate "reverse function" is not required.

According to a second aspect, the present invention also provides a sensor system comprising: a sensor device according to the first aspect wherein the at least two sensors are magnetic sensors for measuring a magnetic field; and wherein the system further comprises a magnetic source (e.g. a permanent magnet, a magnetic dipole, a magnetic quadrupole) for generating said magnetic field, wherein the magnetic source is movable (e.g. rotatable) relative to the sensor device; wherein the sensor device is configured for determining a linear or an angular position of the magnetic source relative to the sensor device.

According to a third aspect, the present invention also provides a sensor system comprising: a sensor device according to the first aspect wherein the at least two sensors are magnetic sensors (e.g. coils), and wherein the system further comprises a printed circuit board comprising said sensor device and comprising at least one transmitter coil for generating an alternating magnetic field; a conductive target which is movable (e.g. rotatable) relative to the printed circuit board and is configured to influence said alternating magnetic field; wherein the sensor device is configured for determining a linear or an angular position of the movable target relative to the sensor device.

In an embodiment, the sensor system of the second or third aspect further comprises an external processor (e.g. ECU) connected to the sensor device; wherein the external processor is configured for one or more of the following: a) for providing a digital test angle (e.g. θgood3) or at least two digital test values (e.g. a sine and cosine value) to the sensor device to perform a diagnostic test, and for receiving a digital position or phase value (e.g. θ2), and wherein the external processor is configured for performing a consistency test between the digital test angle (e.g. θgood3) or the at least two digital test values and the diagnostic position or phase (e.g. θ2); b) for receiving a measurement angle (e.g. θ1) derived from sensor signals (e.g. ss1) obtained from the first set of sensors, and for receiving a diagnostic angle (e.g. θ2) derived from analog test signals (e.g. ats), in turn derived from digital test values (e.g. dtv) provided by a diagnostic controller, in turn derived from the measurement angle (e.g. θ1) by applying a reverse function (e.g. a sine and a cosine function, or three 120° phase shifted sine functions, or four 90° phase shifted sine signals), and wherein the external processor is configured for performing a consistency test between the measurement position or phase (e.g. θ1) and the diagnostic position or phase (e.g. θ2).

According to a fourth aspect, the present invention also provides a method of detecting an error of a sensor device according to the first aspect, or of a sensor system according to the second or third aspect, the method comprising the steps of: a) generating a plurality of at least two analog test signals (e.g. ats) related to a test vector having known digital test values (e.g. dtv) or derived from a known position or phase (e.g. θgood) ; b) routing the plurality of at least two analog test signals (e.g. ats) to a forward signal path that comprises: an analog circuit having at least one amplifier, followed by a digitizer circuit having at least one analog-to-digital convertor for generating a set of at least two digital values (dv), followed by a digital-signal-processor; c) optionally calculating by the digital processing circuit a position value or a phase value (e.g. θ2) (e.g. a linear position, a phase, an angular position) based on the set of at least two digital values (e.g. dv) provided by the digitizer circuit, (e.g. based on a ratio of two digital values derived from said digital values, e.g. as an arctangent function of said ratio); d) detecting an error by performing a consistency test based on a comparison of the at least two digital values (e.g. dv) and/or of the position or phase (e.g. θ2) determined by the DSP on the one hand, and the known digital test values (e.g. dtv) and/or the known position or phase (e.g. θgood) on the other hand.

In an embodiment, step a) comprises: generating two quadrature signals, e.g. a sine and a cosine signal having a certain amplitude, e.g. a predefined or configurable amplitude.

In an embodiment, step a) comprises: generating three 120° phase shifted sine signals.

In an embodiment, step a) comprises: generating four 90° phase shifted sine signals.

In an embodiment, step a) comprises: obtaining at least two digital test values from a non-volatile memory device, and optionally modifying these values (e.g. by one or more of the following: scaling, adding or subtracting an offset, adding noise, by applying a temperature dependent inverse sensitivity correction).

In an embodiment, step a) comprises: obtaining at least two digital test values from an external processor, and optionally scaling these values.

In an embodiment, step a) comprises: obtaining a phase or an angle value from the DSP resulting from a previous measurement (in mode 1) or from a previous diagnostic test (in mode 2), or from an external processor (e.g. ECU), and converting this phase or angle into at least two digital test values, e.g. using at least one sine function, optionally with a phase shift, and optionally with interpolation, or using at least two tables or lists stored in a non-volatile memory, e.g. by applying a sine and a cosine function, or by determining three 120° phase shifted sine values, or by determining four 90° phase shifted sine values.

In an embodiment, the consistency test of step d) is performed by the sensor device itself.

In an embodiment, the consistency test of step d) is performed by an external processor (e.g. ECU).

In an embodiment, step b) is performed using one or more of the following: a multiplexer, a switch, a tristate-buffer.

Particular and preferred aspects of the invention are set out in the accompanying independent and dependent claims. Features from the dependent claims may be combined with features of the independent claims and with features of other dependent claims as appropriate and not merely as explicitly set out in the claims.

These and other aspects of the invention will be apparent from and elucidated with reference to the embodiment(s) described hereinafter.

### Brief description of the drawings

**FIG. 1** shows a high level block diagram of a sensor device known in the art, without diagnostic capabilities.
**FIG. 2** shows a high level block diagram of a sensor device known in the art, with diagnostic capabilities.
**FIG. 3A and FIG. 3B** shows a high level block diagram of a sensor device according to embodiments of the present invention. In **FIG. 3A****,** the device is configured in a first mode for measuring a physical quantity (e.g. a phase or an angle) based on signals obtained from sensors or transducers. In **FIG. 3B****,** the device is configured in a second (diagnostics) mode of operation, for allowing an error to be detected.
**FIG. 3C** shows a variant of FIG. 3A and FIG. 3B having two sets of input nodes, a single three-way multiplexer, and a single forward data path.
**FIG. 4A to FIG. 11** show variants of the sensor device of FIG. 3A and FIG. 3B, illustrating other embodiments of the present invention. Some embodiments have a single forward signal path. Other embodiments have two forward signal paths.
**FIG. 12** shows a flow-chart of a method of detecting an error of a sensor device, as another embodiment of the present invention.
**FIG. 13A to FIG. 16** show high level block diagrams of other sensor device according to embodiments of the present invention.
**FIG. 17** shows an illustrative example of a simple 3-bit DAC circuit, known in the art, as may be used in embodiments of the present invention.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

In this document, the expression "interconnection stack" or "metal stack" refer to a stack of layers comprising at least two (e.g. four) "wire layers" of conductive material (e.g. Al or Cu) separated by layers comprising dielectric material. The "wire layers" are typically patterned and typically comprise a plurality of tracks and/or regions for conducting electrical signals or regions forming contact areas (e.g. bond pads). Wires of different wire layers may be interconnected using "vias".

In this document the term "sensor" or "transducer" may refer to any kind of component or device capable of converting a physical quantity (such as e.g. light, sound, pressure, magnetic field) into an electrical signal (e.g. a current signal or a voltage signal). In preferred embodiments of the present invention, the sensor or transducer may be an electrical coil for measuring a magnetic field, or a magnetic sensor element (such as e.g. a horizontal Hall element, a vertical Hall element, a magneto-resistive element, e.g. an AMR, GMR, TMR, XMR element).

In this document the term "analog signal processor" (abbreviated herein as ASP), means "an electrical circuit configured for receiving at least one analog signal, or at least two analog signals, and for processing this/these analog signal(s) in the analog domain, and for providing at least one, or at least two analog signals. The ASP comprises at least one analog amplifier, but may also comprise a demodulator, an adder, a subtractor, an analog filter, a delay element, etc.

In this document, the terms "analog-to-digital convertor" (abbreviated as ADC) and "digitizer" mean the same.

In this document, DAC means "digital-to-analog convertor".

In this document, the "digital-to-analog conversion circuit" or "DAC circuit" refers to a circuit capable of converting multiple digital signals into analog signals. Depending on the implementation, the DAC circuit may comprise multiple DACs, or may comprise a single DAC and optionally other circuitry, e.g. a sample-and-hold circuitry, or may contain a shift register and a single DAC. The DAC circuit may be configured for providing the multiple analog signals at its output simultaneously (in parallel) or one at the time (e.g. time-multiplexed). In the detailed description, it will be assumed that the "digital-to-analog-conversion circuit" contains a plurality of DACs for ease of the description, hence the expressions "digital-to-analog conversion circuit "and "DAC circuit" and "DACs" can be used interchangeably.

In this document, ADC means "analog-to-digital convertor".

In this document, DSP means "digital signal processing circuit" (e.g. a custom digital circuit) or "digital signal processor". The processor may be programmable, meaning that it can execute instructions stored in a non-volatile memory (e.g. ROM or FLASH), or may be configured to perform a hard-coded function.

In this document the expression "second mode" or "diagnostic mode" or "self-test mode" or "evaluation mode" mean the same, unless explicitly stated or clear from the context otherwise.

The abbreviation NV-memory means "non-volatile memory".

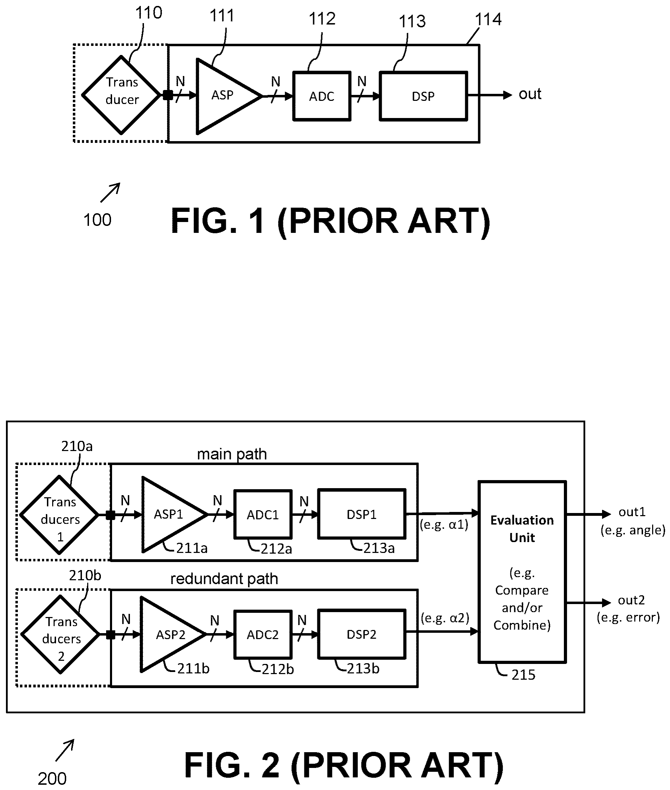

In this document the expression "forward signal path" and "processing chain" mean the same, unless explicitly stated or clear from the context otherwise. In the context of the present invention, this expression usually refers to the circuit that comprises the ASP, the ADC and the DSP (see e.g. block 114 of FIG. 1).

In this document, the expressions "approximately (equal to)" and "substantially (equal to)" means within a tolerance margin of ±5%, or within a tolerance margin of ±2%, or within a tolerance margin of ±1%, unless explicitly mentioned otherwise.

In this document, the expression "2D magnetic sensor" or "2D magnetic pixel" mean the same.

In this document, the expression "3D magnetic sensor" or "3D magnetic pixel" mean the same.

In this document, the expression "in-plane component of a magnetic field vector" and "projection of the magnetic field vector in the sensor plane" mean the same. If the sensor device is or comprises a semiconductor substrate, this also means a "magnetic field component parallel to the semiconductor plane". These components may be labelled Bx, By.

In this document, the expression "out-of-plane component of a magnetic field vector" and "Z component of the vector" and "projection of the vector on an axis perpendicular to the sensor plane" mean the same. This component may be labelled Bz.

Embodiments of the present invention are typically described using an orthogonal coordinate system which is fixed to the sensor device, and having three axes X, Y, Z, where the X and Y axis are parallel to the substrate, and the Z-axis is perpendicular to the substrate.

In this document, the expression "spatial derivative" or "derivative" or "spatial gradient" or "gradient" are used as synonyms. If the order of the derivative is not explicitly mentioned, a first order gradient is meant, unless clear from the context otherwise. In the context of the present invention, the gradient is typically determined as a difference between two values measured at two locations spaced apart along a certain direction. In theory the gradient is typically calculated as the difference between two values divided by the distance between the sensor locations (e.g. dx), but in practice the division by said distance is often omitted, because the measured signals need to be scaled anyway. Hence, in the context of the present invention, the expression "magnetic field difference" and "magnetic field gradient" can be used interchangeably.

In this application, horizontal Hall plates are typically referred to by H1, H2, etc., signals obtained from horizontal Hall plates are typically referred to by h1, h2, etc., vertical Hall plates are typically referred to by V1, V2, etc., and signals obtained from vertical Hall plates are typically referred to by v1, v2, etc.

The function atan2() is the two-argument arctangent function, known in the art.

In this document, the expression "second routing mode" and "second mode of operation" and "second mode" can be used interchangeably, although the routing typically refers to the multiplexer, and the mode of operation typically refers to the DSP or the sensor device as a whole, unless clear from the context that something else is meant.

Likewise, the expression "third routing mode" and "third mode of operation" and "third mode" be used interchangeably, unless clear from the context that something else is meant.

The present invention relates to semiconductor sensors suitable for automotive applications having some level of self-diagnostics or self-test capabilities operable during normal operation, or between normal operations of the sensor (e.g. in a time-multiplexed manner), in particular magnetic sensor devices, for example linear or angular position sensor devices, but the present invention is not limited thereto and other sensor devices are also envisioned, such as e.g. pressure sensors. For ease of the description, the present invention will be explained mainly by referring to magnetic sensors, also referred to as "transducers".

As explained in the background section, there is a need for sensor devices having diagnostic capabilities, e.g. self-diagnostics or self-test capabilities, designed to meet or to exceed relevant safety standards or industry standards, such as SIL standards or ASIL standards, preferably without significantly increasing the cost.

### Referring now to the figures,

**FIG. 1** shows a high level block diagram of a sensor device 100 known in the art, without diagnostic capabilities. The sensor device 100 comprises: a sensor or transducer circuit 110, followed by an analog signal processing circuit (ASP) 111, followed by an analog-to-digital (ADC) conversion circuit 112, followed by a digital signal processor (DSP) 113. The DSP is configured to provide an output signal "out" based on the sensor signals. The forward signal path comprising the ASP, ADC and DSP may be implemented in a single semiconductor substrate 114. The sensor or transducer circuit 110 may comprise a plurality of sensors. The sensors 110 may be implemented in the same semiconductor substrate 114 that comprises the ASP and ADC and DSP, but that is not absolutely required, and alternatively the sensors 110 could be external to the semiconductor substrate 114 but electrically connected thereto. In an example, the sensors 110 are two horizontal Hall elements or two vertical Hall elements or two magneto-resistive (MR) elements embedded in the semiconductor substrate 114. In another example, the sensors 110 are two or three coils implemented as copper tracks on a printed circuit board (PCB), and the semiconductor substrate 114 is implemented in a packaged semiconductor device (also known as "chip" or "IC") which is soldered on that PCB. The sensor device 100 shown in FIG. 1 does not have error detection capabilities. It is noted that "/N" used in the drawings means that there are more than one electrical connection, e.g. two or more conductive paths, e.g. for conducting a sine-like signal and a cosine-like signal (in this case N=2), or for conducting three sinusoidal signals (in this case N=3) which are substantially 120° phase shifted apart, or for conducting four sinusoidal signals (in this case N=4) which are substantially 90° phase shifted apart. In preferred embodiments of the present invention, the value N is at least two, e.g. N=2 or N=3 or N=4.

**FIG. 2** shows a high level block diagram of a sensor device 200 known in the art, with diagnostic capabilities. As can be seen, the device 200 has two sub-circuits identical to the circuit of FIG. 1. One of these circuits may be referred to as the "main path", the other as the "redundant path". In the example shown in FIG. 2, the DSP of each sub-circuit provides a measurement value (e.g. DSP1 provides an angle value α1, and DSP2 provides an angle value α2) to an evaluation unit 215. The evaluation unit may be configured for testing if the values provided by DSP1 and DSP2 are consistent, and for raising an error if they not consistent. If the signals are consistent, one of the values, e.g. α1, or a combination of the signals, e.g. an average of α1 and α2, may be provided as the overall output signal out1.

It is known in the art to use two identical paths, known as a "homogenous solution". A disadvantage of such a solution is that both paths may suffer from a common error. Another disadvantage is that it requires duplicating the hardware, thus increasing cost and space.

It is also possible to use different circuits for the main path and the redundant path, known as a "heterogeneous solution". In fact, if mere error detection is required, the redundant channel may provide a lower quality, which may be beneficial for cost reasons, but such a solution would no longer be capable of continuing to operate with high accuracy, if an error was detected.

**FIG. 3A** shows a high level block diagram of a sensor device 300 according to an embodiment of the present invention. The sensor device 300 has diagnostic capabilities, or stated in other words, has error detection capabilities.

The sensor device 300 of FIG. 3A comprises a set of at least two input nodes 319 (e.g. voltage nodes, e.g. in the form of elongated leads, or connector pins) for receiving a set of at least two sensor signals "ss1" (e.g. voltage signals or current signals) from a set of sensors or transducers 310. The signals ss1 may be indicative of a position (e.g. a linear or an angular position of an object, e.g. of a magnet) or a phase to be measured.

The sensor device 300 further comprises: a forward signal path (311, 312, 313) comprising:
- an analog circuit (ASP) 311 comprising at least one amplifier (not explicitly shown) configured for amplifying at least two input signals "is" (e.g. a sine and a cosine signal, or three 120° phase shifted signals, or four 90° phase shifted signals) or signals derived therefrom (e.g. by summing, subtracting and/or scaling input signals, e.g. to convert three 120° phase shifted signals into quadrature signals, e.g. to convert four 90° phase shifted signals into two orthogonal difference signals), and for providing at least two amplified signals "as";
- an analog-to-digital convertor circuit (ADC) 312 configured for digitizing the amplified signals "as", and for providing at least two digital values "dv";
- a digital processing circuit (DSP) 313 configured for determining a ratio of said at least two digital values "dv", and further configured for determining a position or phase (e.g. θ1) as a function of said ratio.

The sensor device 300 further comprises:
- a "digital-to-analog conversion circuit" 317, also referred to as "DAC circuit", comprising at least one DAC (digital-to-analog-convertor), and optionally other components such as e.g. a sample-and-hold component. The DAC circuit may be configured for generating at least two analog test signals "ats" (e.g. simultaneously or sequentially). The DAC circuit may comprise one or two or three digital-to-analog convertors (DACs). In some embodiments, the DAC(s) may have a resolution of at least eight bits. In some embodiments, the DAC(s) may have a resolution of at most five, or at most four or at most three bits;
- a diagnostic controller 316 configured for providing at least two digital test values "dtv" to the at least two DACs 317 for generating at least two analog test signals "ats";
- a router or routing circuit 318 (e.g. comprising an analog multiplexer MUX, and/or a plurality of switches and/or tri-state buffers or the like) configurable for selectively routing the at least two sensor signals "ss1" from the input nodes 319 as input signals "is" to the analog circuit (ASP) 311 in a first routing configuration, or for routing the at least two analog test signals "ats" from the DAC circuit 317 as input signals "is" to the analog circuit (ASP) 311 in a second routing configuration.

**FIG. 3A** shows the sensor device 300 configured in a first mode of operation for determining said position or phase (e.g. θ1) by routing the at least two sensor signals "ss1" as input signals "is" to the analog circuit (ASP) 311, and by further processing these signals in the forward data path 323.

**FIG. 3B** shows the sensor device 300 configured in a second mode of operation for determining a test position or a test phase (e.g. θ2) by routing the analog test signals "ats" generated by the DAC circuit 317 as input signals "is" to the analog circuit (ASP) 311, and by further processing these signals in the forward data path 323.

The routing circuit (or multiplexer) 318 may be configured in the first or second mode by means of a control signal mux_ctrl. This signal may be generated by the DSP 313, or by the diagnostic controller 316, or by another component (not shown in FIG. 3A or FIG. 3B).

By starting from known digital test values "dtv", and by generating known analog test signals "ats" (by the DAC circuit 317), and by applying these known analog test signals "ats" as input signals "is" at the input of the processing chain to be tested (via the MUX 318), and by processing these known analog signals "ats" by the forward signal path 323 comprising at least said ASP 311, ADC 312 and DSP 313 (e.g. in the second configuration mode), the sensor device 300 allows error detection of the hardware and/or software components of the "forward signal path" 323, because the signal (e.g. θ2) provided at the output of the DSP 313 can be compared with a "known good result" corresponding with the digital test values "dtv", despite loss of information due to the ratio calculation.

These are the main underlying ideas of the present invention. Many variants are possible, e.g.
(i) depending on where the consistency test between the signal provided by the DSP and the "known good result" is performed (e.g. inside or outside of the sensor device; e.g. in an evaluation unit outside of the DSP, or by the DSP itself); and/or
(ii) depending on where the digital test values "dtv" come from (e.g. from a local non-volatile memory, from an external processor, derived from a previous measurement or from a previous evaluation of test values); and/or
(iii) depending on the form in which the digital test values are provided (e.g. as at least two virtual sensor values, or as an angle or phase value which is to be converted into two digital test values, e.g. a sine and a cosine value); and/or
(iv) the sensor device may have only one forward data path, or may have two forward data paths (e.g. referred to as "a main path and a redundant path");
(v) the sensor device may have only one set of input nodes (and e.g. a two-way multiplexer), or may have two sets of input nodes (and e.g. a three-way multiplexer);
(vi) the consistency test may be based on a comparison of two angle or phase values provided by the DSP (e.g. θ1 derived from sensor signals ss1 versus θ2 derived from analog test signals), or may be based on a comparison of the digital test values "dtv" provided by the diagnostic controller and the digital values "dv" provided by the ADC;

It is pointed out that many combinations of these variations are possible, but not all possible combinations are shown as separate drawings.

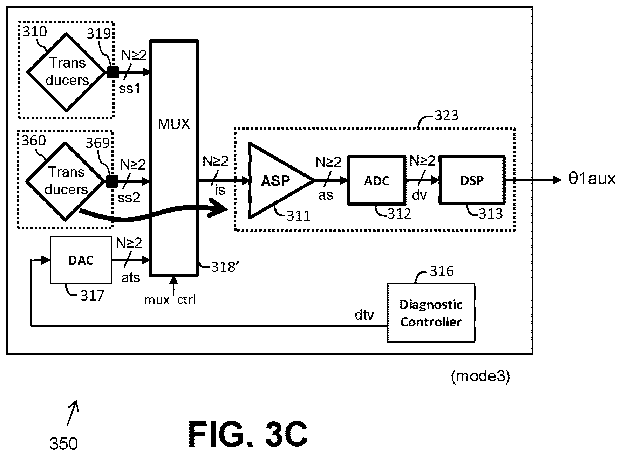

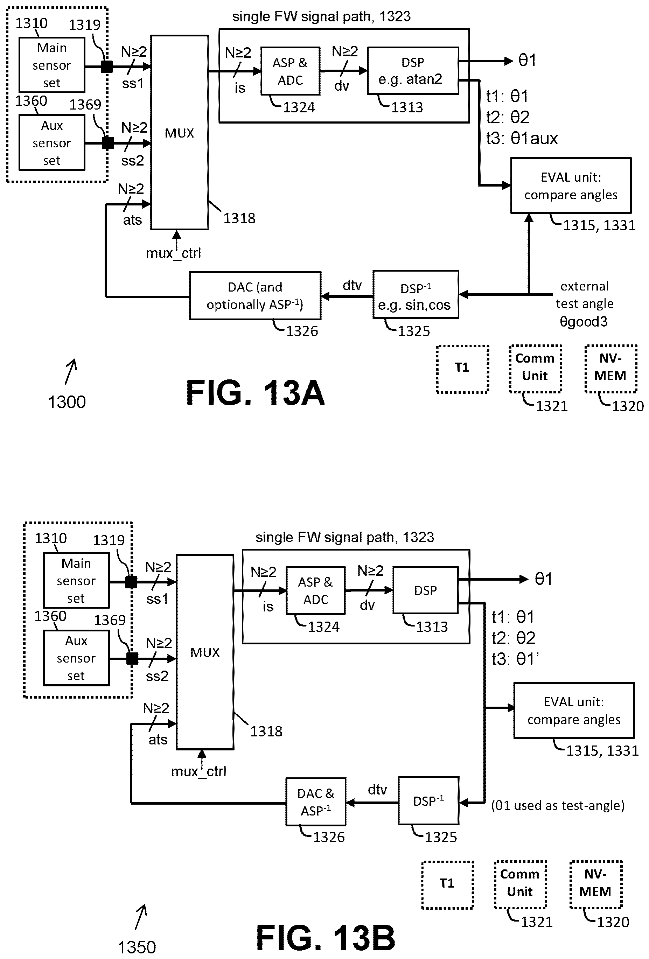

Several variants will be described and illustrated in FIG. 3C to FIG. 11 and in FIG. 13A to FIG. 18, but before doing so, the circuit 300 of FIG. 3A and FIG. 3B will be described in more detail.

As mentioned above, the Analog Signal Processor ASP 311 comprises at least an amplifier, but in practice it may comprise also other circuitry, such as e.g. a temperature sensor, a sensitivity correction circuit (as a function of temperature), a biasing and readout circuit, an analog filter (e.g. a low-pass filter or a band-pass filter), a demodulator (e.g. an AM demodulator), etc. For ease of the description, however, the ASP-block 311 may simply be referred to as "amplifier block".

As mentioned above, the DSP 313 is capable of determining a ratio of two digital values, and of determining a phase (e.g. by applying an arctangent function, or by applying the atan2 function). In particular embodiments, the DSP 313 may also be capable of performing one or more of the following tasks: pairwise subtracting signals, calculating an average of signals, performing a Clarke Transformation to convert three 120° phase shifted signals into two quadrature signals, performing an arctangent function, determining an amplitude (or a norm) of the vector represented by the two or three or four digital values (e.g. by calculating a sum of two or more squares), normalizing said vector by dividing each individual signal by said norm, etc.

In an embodiment, the "sensor device" 300 is or comprises a single semiconductor die, e.g. a CMOS substrate comprising not only the components of the "forward signal path" (ASP 311, ADC 312, and DSP 313), but preferably also one or more or all of the following: the Diagnostic Controller 316, the DAC circuit 317, the routing circuit 318 (e.g. MUX or switches or tristate buffers), and optionally also the sensors or transducers 310.

In an embodiment, the "sensor device" 300 is a packaged semiconductor device (typically referred to as "chip" or "IC"), comprising a semiconductor die with the components shown in FIG. 3A, but not necessarily the sensors or transducers 310, who may be embedded in the semiconductor die, but do not have to be embedded in or on the semiconductor die. It suffices that they are electrically connected thereto via the input nodes 319. As an example, the sensor device 300 may comprise a first semiconductor die being a CMOS substrate comprising at least the ASP 311, ADC 312, DSP 313, and preferably also MUX 318, DAC 317 and Diagnostic Controller 316, and comprise a second semiconductor die comprising the sensors or transducers 310, and optionally other circuitry such as e.g. a temperature sensor, a biasing circuit. The second semiconductor die may also be a CMOS substrate, or may comprise a compound semiconductor material selected from the III-V-group, for example Ga-As or In-As. Both semiconductor dies would be electrically interconnected, and packaged in the same semiconductor device.

In an embodiment, the "sensor device" 300 comprises a printed circuit board (PCB) comprising conductive tracks forming a plurality of coils, and a packaged semiconductor device mounted on the PCB. The packaged semiconductor device may comprise a first semiconductor die, e.g. a CMOS substrate comprising at least ASP 311, ADC 312, DSP 313, and preferably also MUX 318, DAC 317 and Diagnostic Controller 316. The first semiconductor die may be electrically connected to said coils via pins or "elongated leads" of the packaged device.

In another or a further embodiment, the sensor device 300 may comprise a single semiconductor substrate comprising a plurality of coils implemented in the "interconnection stack".

In another or a further embodiment, the sensor device 300 may comprise two semiconductor substrates, one of them comprising at least said ASP 311, ADC 312, DSP 313, MUX 318, the other semiconductor substrate comprising at least a plurality of coils implemented in the "interconnection stack".

In an embodiment, the semiconductor die comprises at least a first set of two magnetic sensors, or a first set of at least three magnetic sensors, or a first set at least four magnetic sensors, e.g. selected from the group consisting of Horizontal Hall elements, vertical Hall elements and magneto-resistive (MR) elements (e.g. AMR, GMR, TMR, XMR). The magnetic sensors may e.g. comprise at least one horizontal Hall element and at least one vertical Hall element, or may comprise at least three horizontal Hall elements, or may comprise four horizontal Hall elements without IMC ("integrated magnetic concentrator"), or may comprise four horizontal Hall elements arranged near the periphery of an IMC disk.

In an embodiment, the sensor device has a first set of two magnetic sensors 310 (e.g. integrated in the semiconductor die, or encapsulated in the same packaged chip, or formed as copper tracks of a PCB) configured (e.g. having a size and/or shape and/or orientation) for providing quadrature signals (during actual use of the sensor device), i.e. two sinusoidal signals having substantially the same amplitude and being phase shifted by approximately 90°.

In an example, the sensor device comprises two vertical Hall elements, preferably integrated in the semiconductor die, having a first and a second axis of maximum sensitivity which are perpendicular to each other (e.g. oriented in an X and Y direction, parallel to the semiconductor die).

In an embodiment, the sensor device comprises a disk shaped integrated magnetic concentrator (IMC) and four horizontal Hall elements, located near a periphery of the IMC and angularly spaced from each other by multiples of 90°. Assuming that the elements are labelled H1 to H4 when moving in a clockwise direction around the IMC, and assuming that H1 and H3 are located on the X-axis and H2 and H4 are located on the Y-axis, the difference (h1-h3) is proportional to a magnetic field component Bx oriented in the X-direction, and the difference (h2-h4) is proportional to a magnetic field component By oriented in the Y-direction. The subtraction is preferably performed in the analog domain, before amplification, but could also be performed in the analog domain after amplification, or in the digital domain (after amplification and digitization). When used in conjunction with a two-pole magnet, (e.g. with a diametrically magnetized disk magnet in an angular position sensor system), the difference signals (h1-h3) and (h2-h4) are substantially quadrature signals.

In an embodiment, the sensor device comprises four horizontal Hall elements without an IMC, located on a virtual circle or a virtual ellipse, and angularly spaced from each other by multiples of 90°. Assuming that the elements are labelled H1 to H4 when moving in a clockwise direction around the IMC, and assuming that H1 and H3 are located on the X-axis and spaced apart by distance dx, and that H2 and H4 are located on the Y-axis and spaced apart by distance dy, the difference (h1-h3) is proportional to a magnetic field gradient dBz/dx, and the difference (h2-h4) is proportional to a magnetic field gradient dBz/dy. The subtraction is preferably performed in the analog domain, before amplification, but could also be performed in the analog domain after amplification, or in the digital domain (after amplification and digitization). When used in conjunction with a two-pole magnet, (e.g. with an axially magnetized disk magnet in an angular position sensor system), the difference signals (h1-h3) and (h2-h4) are substantially quadrature signals. Moreover, these signals are largely insensitive to an external disturbance field, and are largely insensitive to position offset. In an embodiment, the sensor device comprises four DACs (e.g. 317), and the routing circuit (e.g. MUX 318) injects the four analog test signals "ats" instead of the sensor signals "ss1" coming from the four Hall elements, before being pairwise subtracted. In another embodiment, the sensor circuit further comprises a subtraction circuit for providing the difference signals (h1-h3) and (h2-h4), optionally after amplification, and the sensor device comprises two DACs, and the routing circuit (e.g. MUX 318) injects two analog test signals "ats" into the ASP 311 instead of the difference signals (h1-h3) and (h2-h4) coming from the subtraction circuit.

The DSP 313 may be or may comprise a programmable processor comprising or connected to a non-volatile memory (e.g. flash), not explicitly shown in FIG. 3A or FIG. 3B, preferably also implemented on the semiconductor substrate. This NV-memory may comprise executable instructions to be performed by the DSP, but may also comprise other data, such as e.g. calibration data to fine-tune or trim the "processing chain" formed by the ASP and ADC and DSP also referred to as the "forward data path" 323, such as e.g. one or more of: a correction factor and/or an offset-value for correcting the behaviour of the at least one amplifier, a correction factor and/or an offset-value for correcting the behaviour of the at least one ADC), etc. The NV-memory may of course also contain other data, such as e.g. configuration data that controls the behaviour and/or the performance of the IC.

While shown as separate blocks in FIG. 3A and FIG. 3B, the DSP 313 and the diagnostic controller 316 may be implemented by a single hardware block.

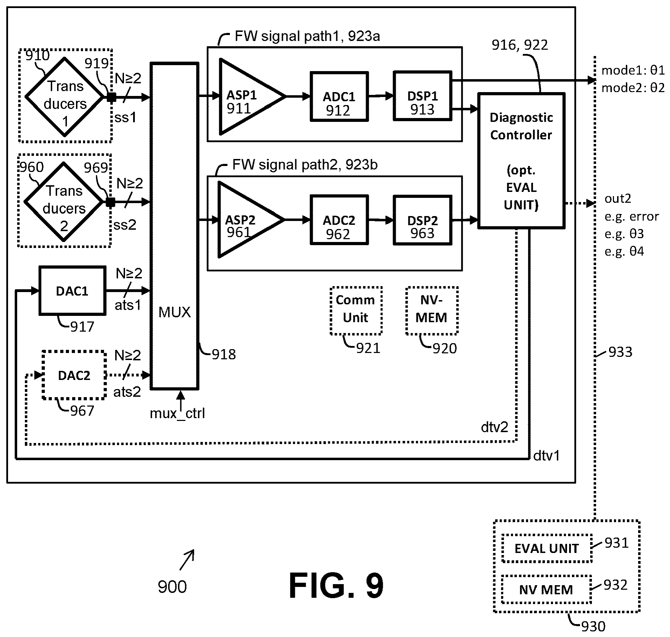

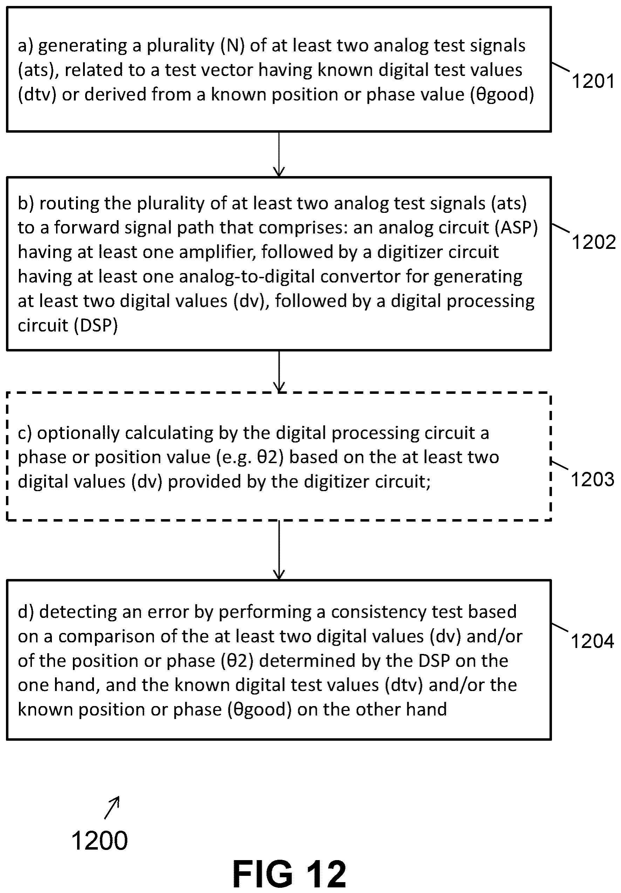

The DSP 313 of the sensor device 300 may be ASIL-D compliant, but that is not absolutely required for the invention to work. In fact, this statement is not limited to the sensor device of FIG. 3A, but applies to all embodiments of the present invention (e.g. as illustrated in FIG. 3A to FIG. 11, and in FIG. 12 to FIG. 17). And in case the sensor device comprises more than one DSP, e.g. two DSP's (as in FIG. 8 or FIG. 9), this applies to each DSP.

**FIG. 3C** shows yet another or a further variant of FIG. 3A and FIG. 3B, the sensor device 350 further comprises a second set of at least two nodes 369 connectable to a second set of sensors 360 for receiving a second set of at least two sensor signals ss2 also indicative of said position or phase to be measured. The multiplexer 318' is a three-way-multiplexer configurable to route either (a) the first set of at least two sensor signals "ss1" coming from the first set of at least two sensors 310, or (b) the analog test signals "ats" coming from the one or more DACs 317, or (c) the second set of at least two sensor signals "ss2" from the second set of at least two sensors 360, to the forward data path 323; and the DSP 313 is configured to respectively provide (a) a first angle or phase value θ1 derived from the sensor signals ss1, (b) a test value θ2 derived from the test signals ats, and (c) a second angle or phase value θ1aux derived from the sensor signals ss2.

The main advantage of the embodiment of FIG. 3C is that it has full redundancy of the sensors, e.g. as generally required by highest integrity requirements standards (e.g. ASIL-D), while using uniquely a single channel for selectively providing the sensed data to the digital signal processor for processing. This is possible as the single channel's operational integrity is repeatedly (e.g. periodically or on-request) verified by the diagnostic controller, leading to a more compact and cost-efficient sensor solution for highest functional safety applications. Moreover, in case the sensor device has been configured, arranged, and/or designed so as to have a processing bandwidth lower than the maximal provided by the sensor's components, the sensor device can be advantageously configured to execute (preferably repeatedly and/or regularly and/or on-request) intra-output verification. In such configuration, the sensor device verifies the channel integrity (e.g. by operating in the second mode of operation, as previously described) between consecutive computations of positions or phases (e.g. sensor device operating in the first or third mode) without any output interruption and/or delay. In other words, the sensor device can be advantageously configured to sequentially operate in the second mode after having operated in the first or third mode and before operating in the first or third mode, and without interrupting and/or delaying a sequence of positions or phases being outputted by the sensor device and/or provided to the external device.

In an embodiment, the first set of sensors and the second set of sensors are two distinct sensor arrangements, each comprising separate sensor elements. The first set of sensors and the second set of sensors may be arranged for measuring substantially the same angle or phase (e.g. within a predefined tolerance margin smaller than e.g. ±2°, or smaller than ±1°). In a variant, the first set of sensors is arranged for measuring a first phase or angle, and the second set of sensors is arranged for measuring a second phase or angle, having a predefined offset from the first phase or angle (e.g. in the range from 15° to 65°, e.g. equal to about 30°, or equal to about 45°, or equal to about 60°).

Everything else described above for FIG. 3A and FIG. 3B is also applicable here, mutatis mutandis.

**FIG. 4A** shows a sensor device 400 which can be seen as a variant of the sensor device 300 of FIG. 3A and FIG. 3B. The main difference between the sensor device 400 of FIG. 4A and the sensor device 300 is that the sensor device 400 further comprises a non-volatile memory 420 containing a list of predefined, known test-data, and an evaluation unit 415 configured for performing a consistency check between a known "good" output value, e.g. an angle or phase value θgood, and a calculated test value θ2 provided by the "processing chain" configured in the second mode.

In an example where the sensor device 400 contains two sensors or two transducers configured for providing a sine and a cosine signal, and wherein the DSP 313 is configured for determining a ratio of the sine and cosine signal, and for determining an angle or a phase as a function of the ratio, e.g. using an arctan or atan2 function of that ratio, the non-volatile memory 420 may for example comprise a plurality of datasets, each dataset comprising three values: an angle or phase value θgood (e.g. the "known good angle"), a digital sine value and a digital cosine value corresponding to θgood, optionally scaled by a predefined factor.

In order to test the sensor device 400, the diagnostic controller 416 may read a particular dataset from the non-volatile memory 420, and provide for example the digital sine and digital cosine value to the DACs 417, and provide the (known good) angle or phase value θgood to the evaluation unit 415; the DACs will convert the digital sine and cosine value "dtv" into an analog sine and cosine signal "ats"; the router or multiplexer 418 will be configured in the second mode and route the analog sine and cosine signals provided by the DACs to the input of the ASP 411 (in the second routing mode), the ASP 411 will process these signals in the analog domain, e.g. amplify these analog signals; the ADC 412 will digitize the amplified signals and provide two digital values "dv"; the DSP 413 may calculate a ratio of these digital values, and calculate a test angle value θ2, e.g. using an arctangent function. The evaluation unit 415 can then perform a consistency test between the known good angle θgood obtained from the non-volatile memory 420 (obtained directly or via the diagnostic controller 416), and the calculated test angle θ2 derived from the digital test signals "dtv" also obtained from the NV-memory 420, and may output a result of the consistency test, e.g. as an error signal.

In an embodiment, the evaluation unit 415 may for example calculate a difference Δθ between the angle θgood and the calculated angle θ2, and test if that difference is situated in a predefined tolerance range, e.g. in the range from -2.0° to +2.0°, or a smaller range, but another consistency test may also be used, e.g. based on a ratio of the two angle values (which should be substantially equal to 1.0).

In an embodiment, the non-volatile memory 420 comprises more than ten (10) data-sets, or more than twenty (20) data-sets, or more than thirty (30) data-sets, or more than forty (40) data-sets, or more than fifty (50) data-sets. Preferably each data-set has at least three values: a phase or angle value, a first sine value of that angle, and a second sine value of that same angle but phase-shifted by 90° or by 120°. The sine values in the non-volatile memory 420 may be scaled by a predefined factor (amplitude) before storage in the non-volatile memory. The sine values obtained from the non-volatile memory may optionally be scaled (or further scaled) and/or optionally "inverse sensitivity corrected" by the diagnostic controller 416, before applying them to the DAC circuit 417.

In an embodiment, the sensor device 400 has a first set of three nodes 419 connected or connectable to three sensors 410 (or three transducers) configured for providing three 120° phase shifted sine signals, and the sensor device has three DACs 417, and the non-volatile memory 420 contains a plurality of datasets, each dataset comprising four values: an angle or phase value (e.g. the "known good angle" θgood), a first digital value corresponding to the sine of that (good) angle, a second digital value corresponding to the sine of that (good) angle after 120° phase shift, and a third digital value corresponding to the sine of that (good) angle after 240° phase shift. The diagnostic controller 416 may apply the three sine values obtained from the NV-memory "as such" to the DACs 417, and/or may modify the digital test values as a function of temperature (using e.g. temperature T1 or temperature T2), and/or may scale the sine values before applying them to the DACs 417. The router or mux 418 is configured (in the second routing mode) to route the three analog sine test signals "ats" to the input(s) of the ASP 411, the ASP may amplify the three sine signals, the ADC 412 may digitize the three amplified sine signals, the DSP 413 may perform a Clarke transformation to convert the three (120° phase shifted) sine values into two (90° phase shifted) values, and may divide these two signals to obtain a ratio, and may calculate test angle θ2 as an arctangent function of that ratio. The evaluation unit 415 may perform a consistency test of the test value θ2 and the angle value θgood obtained from the NV-memory 420, e.g. by determining a difference between them, and by testing if an absolute value of this difference is smaller than a predefined threshold value, e.g. smaller than 2.0°, or smaller than 1.5°, or smaller than 1.0°, or smaller than 0.5°, or in another suitable manner.

In an embodiment, the sensor device 400 has four sensors (e.g. four horizontal Hall elements H1, H2, H3, H4) and an analog circuit (outside of the ASP 411, e.g. on the left side of the MUX of FIG. 4A) configured for determining two pairwise differences, e.g. (h1-h3) and (h2-h4), e.g. indicative of Bx and By, or indicative of dBz/dx and dBz/dy; and in the first mode of operation of the sensor device (and the first routing-mode of the multiplexer), these two anaog difference signals are routed via the MUX 418, and are applied as two input signals "is" to the ASP block 411. These difference signals may be quadrature signals. The ADC 412 may digitize these difference signals. The DSP 413 may calculate a ratio, and determine an angle θ1 based on said ratio, e.g. by applying an arctan function, and optionally by applying a further function, e.g. a further scaling and/or offset by a customer value, or a linearization function using calibration parameters stored in a non-volatile memory (e.g. the same non-volatile memory 420, or another non-volatile memory). The sensor device may comprise two DACs 417, and the datasets may comprise three values: an angle, a sine value and a cosine value. In evaluation mode, the diagnostic controller 416 would apply two test-signals, namely a sine value and a cosine value ("dtv") to the two DACs 417, optionally after scaling and/or inverse sensitivity correction, the router or MUX 418 would be configured in the second mode for routing the outputs of the two DACs 417 to the ASP block 411, and the "processing chain" 423 or "forward data path" 423 comprising the ASP, ADC and DSP would calculate a second angle θ2 (or test angle) based on the two test signals "dtv". The evaluation unit 415 can then test a consistency between the values θgood obtained from the non-volatile memory 420, and the value θ2 calculated by the processing chain, and may output a result of the test as an error signal (or validity signal).

In an embodiment, the sensor device 400 also has four sensors (e.g. four horizontal Hall elements H1, H2, H3, H4), and has an analog circuit for determining two pairwise differences, e.g. (h1-h3) and (h2-h4), but this circuit is part of the ASP block (located on the right side of the MUX of FIG. 4A). In this case, the MUX will route four analog signals to the ASP block: in the first mode of operation four analog sensor signals "ss" are routed to the ASP block; in the second mode of operation four analog test signals "ats" are routed from the DACs 417 to the ASP block. In this embodiment, the sensor device may have four DACs, and the diagnostic controller 416 is configured for providing four digital test-values "dtv" to the DACs 417. The non-volatile memory 420 may comprise a plurality of datasets each comprising five values: (angle, +sine, +cosine, -sine, -cosine), which digital values may be applied by the diagnostic controller 416 to the DACs "as such", or optionally after scaling by a common factor, and/or optionally after inverse-sensitivity correction as a function of temperature (e.g. T1 or T2). But it is also possible that the datasets in the non-volatile memory 420 contain only three values: (angle, sine, cosine) and the diagnostic controller 416 would derive the third and the fourth digital value from the first and second digital value (e.g. by inverting their signs).

As mentioned above, in a simple implementation, the diagnostic controller 416 can simply read digital test values "dtv" from the non-volatile memory 420, and apply them to the DACs 417 without modification. It is also possible, however, that the non-volatile memory 420 stores some but not all of the values that need to be applied to the DACs 417, and that the diagnostic controller 416 calculates additional values based on the values obtained from the non-volatile memory. Additionally or alternatively it is also possible that the diagnostic controller 416 modifies the digital test data obtained from the non-volatile memory 420 before applying them to the DACs, e.g. in one or more of the following ways: by scaling all the values with a common multiplication factor, by subtracting or adding a constant to all the values (e.g. to emulate an external disturbance field), by subtracting a constant from some of the values (e.g. to emulate an offset). In another or a further embodiment, the diagnostic controller 416 may add noise to the digital test values (e.g. to bring some diversity to the values obtained from the NV-memory with a limited random distribution, making the comparison with the "known good value" still valid).

But the Diagnostic Controller may also perform other modifications, such as for example applying a temperature dependent "inverse sensitivity correction", e.g. as explained next:
In an embodiment, the sensor device 400 may comprise a first temperature sensor T1, and the forward data path 423 (e.g. the ASP or the DSP) may be configured for correcting the sensitivity of the sensor elements as a function of the measured temperature T1 when operating in the first mode of operation. When configured in the second mode of operation, the sensor device 400 may operate in one of the following ways,:
(i) the Diagnostic controller 416 may be configured to provide the test_data obtained from the NV-memory 420 without modification, and the forward data path 423 may be configured to perform a "sensitivity correction" of the input signals "is", despite the fact that these input signals are not provided by the sensors or transducers. Even though the "sensitivity correction" will distort individual signals, the output signal θ2 calculated by the forward data path 423 may still be good enough for performing a consistency test with the "known good" value θgood using an appropriate threshold margin;
(ii) the sensor device 400 may be configured to disable or deactivate the "sensitivity correction" of the forward data path 423 when operating in the second mode of operation(also referred to as "diagnostic mode"). This offers the advantage that the resulting value θ2 will not be negatively influenced by the sensitivity correction, but has a disadvantage that the function of the forward data path is not the same in the first and second mode of operation;
(iii) the Diagnostic Controller 416 may be configured for modifying the test data obtained from the NV-memory 420 using an "inverse sensitivity correction" function of the temperature T1, (e.g. to compensate for the "sensitivity correction" that will be performed by the forward data path. In this case the "sensitivity correction" of the forward data path can remain active in the second mode of operation, without negatively influencing the accuracy of the output θ2. This offers the advantage that the forward data path 423 is operating in exactly the same manner irrespective of the first or second mode of operation;
(iv) in a variant of (iii), the diagnostic controller 416 would use a temperature value obtained from a second temperature sensor T2, different from the first temperature sensor. This offers the additional advantage of potentially detecting an error associated with the first temperature sensor T1.

In an embodiment, the diagnostic controller 416 is configured to scale the values obtained from the non-volatile memory 420 such that the analog test signals "ats" generated by the DACS will have a predefined amplitude.

In an embodiment, the sensor device 400 operates in the first mode at a first moment in time and the DSP 413 determines or estimates an amplitude of the sensor signals "ss" (e.g. based on a sum of squares of the quadrature signals) before determining a ratio, and provides this amplitude to the diagnostic controller 416, directly or indirectly (e.g. via the non-volatile memory). At a second moment in time the sensor device 400 operates in the second mode for performing a diagnostics evaluation, and the diagnostic controller 416 scales the values obtained from the non-volatile memory 420 such that the analog test signals "ats" generated by the DACS will have an amplitude substantially equal to the amplitude of the sensor signals "ss" which was determined when operating in the first mode. This offers the advantage that the evaluation test is performed with analog test signals "ats" having a similar signal-to-noise (SNR) ratio as the sensor signals "ss".

In a further embodiment, the DSP 413 or the diagnostic controller 416 also provides this amplitude to the evaluation unit 415, and the evaluation unit adjusts the threshold value(s) used in the consistency check depending on said amplitude. For example, if the amplitude is larger than a predefined value, the consistency check may test whether the angular difference Δθ=(θ2-θgood) lies in a first predefined range, e.g. the range from -0.5° to +0.5°, and if the amplitude is smaller than said predefined value, the consistency check may test whether the angular difference Δθ lies in a second predefined range, larger than the first predefined range, e.g. the range from -1.0° to +1.0°. If is of course also possible to use more than two different threshold values or regions, e.g. at least three or at least four different threshold values or regions, depending on the values of said amplitude. This mechanism allows to apply a more stringent test in case the signals levels are relatively high, as opposed to the use of a constant threshold margin irrespective of the sensor signal levels. This mechanism may even be used to monitor chip degradation over time.

While shown as separate blocks in FIG. 4A, some or all of the DSP 413, the Diagnostic Controller 416 and the Evaluation Unit 415 may be combined. In a preferred embodiment, the three blocks DSP 413, the Evaluation Unit 415 and the Diagnostic Controller 416 are all implemented by a single hardware block.

Everything else described above for the sensor device 300 illustrated in FIG. 3A and FIG. 3B is also applicable for the sensor device 400 of FIG. 4A, mutatis mutandis.

**FIG. 4B** shows yet another or a further variant of FIG. 4A, wherein the sensor device 450 further comprises a second set of at least two nodes 469 connectable to a second set of sensors or transducers 460 for receiving a second set of at least two sensor signals ss2 also indicative of said position or phase to be measured (e.g. the same position or phase as the one indicated by the signals ss1, or optionally offset by a predefined constant). The multiplexer 418' is a three-way-multiplexer configurable to route either (a) the first set of at least two sensor signals "ss1" coming from the first set of at least two sensors 410, or (b) the analog test signals "ats" coming from the one or more DACs 417, or (c) the second set of at least two sensor signals "ss2" from the second set of at least two sensors 460, to the forward data path 423; and the DSP 413 is configured to respectively provide (a) a first angle or phase value θ1 derived from the first set of sensor signals ss1, (b) a test value θ2 derived from the test signals ats, and (c) an angle or phase value θ1aux derived from the second set of sensor signals ss2. The main advantage of the sensor device of FIG. 4B over that of FIG. 4A is that it offers full redundancy of the sensors. Everything else described above for FIG. 4A is also applicable here, mutatis mutandis.

The sensor device 450 can also be seen as a variant of the sensor device of FIG. 3C, with additional components (e.g. NV-memory 420, and evaluation unit 415, and optionally one or two temperature sensors T1, T2), providing the same or similar functionality as described in FIG. 4A.

**FIG. 5** shows a sensor device 500 which can be seen as another variant of the sensor device 300 of FIG. 3A and FIG. 3B, or as a variant of the sensor device 400 of FIG. 4. The main difference between the sensor device 500 of FIG. 5 and the sensor device 300 and 400 is that the sensor device 500 further comprises a communication unit or communication interface 521, for sending and/or receiving data from an external processor 530 (e.g. an ECU, electronic control unit). The sensor device 500 may still be a single semiconductor die, or a packaged semiconductor chip (also referred to as "IC") comprising at least one, e.g. a single semiconductor die. The chip may be soldered on a PCB.

**FIG. 5** also shows a sensor system comprising a sensor device 500 communicatively connected to an external processor 530 (e.g. an ECU) via an external bus 533, e.g. via a serial bus interface. The external processor 530 may comprise an evaluation unit 531 and a non-volatile memory 532.

The skilled reader, when comparing FIG. 4A and FIG. 5, will understand that the sensor system of FIG. 5 can offer the same functionality as the sensor device of FIG. 4A, and the variants described above. Indeed, the sensor device 500 can still operate in a first mode, in which sensor signals "ss" are routed to the ASP block 511, and wherein the DSP 513 provides an output value, e.g. a first angle or phase or position θ1. The sensor device 500 can also be configured in a second mode (or "diagnostics mode"), wherein the diagnostic controller 516 can apply digital test values "dtv" to the DACs 517; the MUX 518 will route them to the ASP 511, and the DSP 513 will calculate a second angle or phase or position θ2. The test_data may be received from the external processor 530, which may read them e.g. from a local non-volatile memory 532 that stores a plurality of datasets in a similar manner as described above (e.g. in FIG. 4A). The test_data may optionally be modified by the external processor 530 and/or by the diagnostic controller 516, e.g. in a similar manner as described in FIG. 4A (e.g. one or more of: scaled, noise added, offset added, inverse sensitivity correction, generate signals with inverted signs) before applying them to the DACs 517. The second value θ2 determined in the second mode of operation, is provided to the external processor 530, for allowing a consistency test to be performed. For example, if the external processor 530 contains an evaluation unit 531 similar to the one described in FIG. 4, this evaluation unit may obtain a "known good angle" θgood from the non-volatile memory 532 corresponding with the test_data provided to the diagnostic controller 516, and may test if the value of θ2 and θgood are consistent, e.g. by testing if a difference Δθ= (θ2 - θgood) lies in a predefined valid range, e.g. in the range from -1.0° to +1.0°, or in an amplitude dependent range (e.g. as described above, see FIG. 4A).

The same or similar variants as described for FIG. 4A are also possible here. For example, the DSP 513 may determine or estimate an amplitude of the sensor signals "ss" measured when operating in the first mode, and the DSP 513 may send this amplitude to the external processor 530 and/or to the diagnostic controller 516, one or both of which may scale the test_data so as to have the same or a similar amplitude as the sensor signals "ss". Optionally the validity range or the threshold values used in the consistency test are adjusted depending on, e.g. as a function of said amplitude.

Everything else described above for FIG. 3A, FIG. 3B and FIG. 4A is also applicable here, mutatis mutandis, for example, the sensor device 500 may also comprise a first and/or a second temperature sensor T1, T2 (not shown in FIG. 5).

In another or a further variant (not shown) of FIG. 5, the sensor device 500 further comprises a second set of at least two nodes connectable to a second set of sensors or transducers for receiving a second set of at least two sensor signals indicative of said position or phase to be measured (e.g. the same position or angle or phase as indicated by the first set of sensor signals, optionally with a predefined offset), and the multiplexer 518 is a three-way-multiplexer, and the DSP 513 is configured to provide a first measurement angle θ1 (when operating in a first mode), a test angle θ2 (when operating in a second mode), and a second measurement angle θ1aux (when operating in a third mode); and the evaluation unit 531 may be further configured to perform a consistency test of two or more of the values θ1, θ2 and θ1aux. The main advantage of this sensor device having a first set of at least two sensors and a second set of at least two sensors, is that it offers full redundancy of the sensors.

**FIG. 6** shows a sensor device 600 which can be seen as a variant of any of the sensor devices shown in FIG. 3A to FIG. 5, wherein the diagnostic controller 622 comprises reverse functions (for example at least one goniometric function, e.g. a sine function and/or a cosine function), and optionally comprises one or more of: (i) a communication unit 621 for communicating with an external processor 630, e.g. an ECU, (ii) a non-volatile memory 620 storing e.g. a plurality of test-values, e.g. a list of angle-values or phase values, (iii) an evaluation unit 615 configured for comparing a position or angle or phase θ2 derived from digital test values "dtv" obtained from NV-memory 620 or received from external processor 630, with a known ("good") position or angle or phase θgood, e.g. θgood2 obtained from the non-volatile memory 620 or θgood3 received from the external processor, when operating in a second mode ("diagnostic mode") of operation.

The main difference between the sensor device 600 of FIG. 6 and the sensor devices of FIG. 3A or FIG. 4A or FIG. 5 is that the diagnostic controller 622 is configured to receive a position value, e.g. an angle or phase value "θgood", and is configured for converting this position value into a set of two or more corresponding digital test values "dtv", which can be converted into a set of analog test values "ats" by the DACs 617, which can then be supplied to the ASP 611 via the MUX 618 in the second mode of operation, so as to be processed by the forward data path 623 comprising ASP 611, ADC 612 and DSP 613 in a similar manner or in the exact same manner as the sensor signals "ss" obtained from the sensors or transducers 610 (when operating in a first mode of operation).

For example, in an embodiment where the sensors or transducers 610 are configured to provide two sensor signals "ss" in the form of a sine and a cosine signal, the analog test signals "ats" should also be a sine and a cosine signal, of a particular amplitude (e.g. substantially equal to the amplitude of the sensor signals "ss", but that is not required). This can be implemented for example by determining a sine function and a cosine function of the angle or phase value "θgood" provided to the "Diagnostic Controller with Reverse Functions" block 622. The sine and cosine may be calculated in known manners, e.g. using one or more look-up tables with or without linear interpolation. In a particular embodiment, a single lookup-table is used twice, a first time to determine sine(θgood), and a second time to determine sine(90°- θgood) which is equal to cos(90°- θgood). After being calculated, the two resulting digital test values "dtv" can then be applied simultaneously or sequentially to the DACs 617 for forming the analog test signals "ats".

The "reverse function" block in the diagnostic controller 622 may implement the reverse or inverse of the "forward function" which is the functionality provided by the "forward signal path" 623 which is composed of the ASP, the ADC and the DSP. The reverse function may be configured by the same or corresponding parameters configuring the "forward function", e.g. parameters defining the order of values in a sequential implementation.

In an embodiment where the sensors or transducers 610 are configured to provide three sensor signals "ss" in the form of three 120° phase shifted sine signals, the analog test signals "ats" should also be three 120° phase shifted sine signals of a particular amplitude. This can be implemented for example by determining a sine function of the angle or phase "θgood" provided to the "Diagnostic Controller with Reverse Functions" block 622, and by determining sin(θgood+120°), and by determining sin(θgood+240°). This can also be implemented using a single look-up table with or without interpolation, three times.

In an embodiment where the sensors or transducers 610 are configured to provide four sensor signals "ss" in the form of four 90° phase shifted sine signals, the analog test signals "ats" should also be four 90° phase shifted sine signals. This can be implemented for example by determining a first digital value dtv1=sin(θgood), a second digital value dtv2=sin(90°-θgood) which is equal to cos(θgood), a third digital value dtv3=-dvt1, and a fourth digital value dtv4=-dtv2. This can be implemented using a single look-up table with or without interpolation, two times, and by inverting the signs of dtv1 and dtv2.

In case the sensors are implemented as coils, the demodulator may be implemented on the left side of the MUX 618, and the sensor signals "ss" may be the three demodulated signals, which are basically three 120° phase shifted sine signals, optionally with a slightly different amplitude.

Many variants of FIG. 6 are possible, e.g.
(i) depending on the number of sensors signals (e.g. two quadrature signals, or three 120° phase shifted signals, or four 90° phase shifted signals, as described above;
(ii) depending on whether the consistency check is performed inside or outside the sensor device 600, (e.g. by an evaluation unit 631 of an ECU).
(iii) depending on the source of the "known good" value θgood which is provided to the diagnostic controller 622 (described further). Indeed, the diagnostic controller 622 may be configured to receive the (known good) value θgood in one or more of the following ways: a) by reading a value θgood2 from a non-volatile memory 620, e.g. similar as described in FIG. 4A; b) by using the result θ1 from the DSP 613 as the result of a previous measurement as a "known good angle" θgood1; c) by receiving a value θgood3 from an external processor, e.g. ECU, via a communication unit 621, similar as described in FIG. 5. In an embodiment, only one of these ways is implemented. In another embodiment, two or all three of these way may be implemented, meaning for example that the sensor device would use a value θgood1 from a previous measurement at a first moment in time, and a value θgood2 obtained from memory at a second moment in time, and the value θgood3 obtained from an external processor at a third moment in time.

If the Evaluation Unit 615 is present inside the sensor device 600, the sensor device itself is capable of performing the consistency test by comparing for example θgood and θ2, where θgood is any of θgood1, θgood2, θgood3 described above, and where θ2 is the angle or phase calculated by the forward data path 623 derived from the digital test values "dtv".

If the Evaluation Unit 615 is not present inside the sensor device 600, the consistency test can be performed by an external processor 630, e.g. an ECU. In this case the value of θgood and θ2 need to be provided to the external processor, e.g. via the output port of the DSP 613, or via the communication unit 621. In some embodiments, the internal evaluation unit 615 performs the consistency test at a first moment in time, and that the external evaluation unit 631 performs the consistency test at a second moment in time.

In another or a further variant, the communication channel 633 (e.g. communication bus) between the external processor 630 and the sensor device 600 via the communication unit 621 may be bi-directional, and the DSP 613 may also be configured for sending and/or receiving information to/from the external processor 630 via the communication unit 621, for example for sending θgood1 and optionally also an estimate of the amplitude of the sensor signals "ss". Similar as described above (see e.g. FIG. 5), an evaluation unit 631 of the external processor 630 may perform the consistency check using a predefined maximum allowed deviation (or a predefined validity region). In case the DSP 613 provides both θgood1 and said estimate of the amplitude of the sensor signals "ss", the maximum allowed deviation may be dependent on said amplitude, or in other words, the maximum allowed deviation may be adjusted dependent on said amplitude.

The sensor device 600 of FIG. 6 has a first set of input nodes 619 connectable to a first set of sensors 610, and has a two-way multiplexer 618, and has a single forward data path 623 with an ASP 611, an ADC 612 and a DSP 613. In another or a further variant (not explicitly shown) of FIG. 6, the sensor device further comprises a second set of at least two input nodes connectable to a second set of sensors for receiving a second set of at least two sensor signals ss2, and the multiplexer 618 is a three-way-multiplexer, and the DSP 613 is configured to determine an angle or phase value θ1 derived from the first set of sensor signals ss obtained from the first set of sensors 610, or to provide a test angle θ2 derived from the analog test signals "ats", or to provide an angle or phase value θ1aux derived from the second set of sensor signals obtained from the second set of sensors, e.g. in a similar manner as explained in FIG. 3B or FIG. 4B, but in this embodiment, the diagnostic controller 622 is configured to convert a known angle (coming from the DSP, or from a memory or from an external processor) into digital test values "dtv"; and/or the consistency test may be performed by an internal evaluation unit 615 or by an external evaluation unit 631.

**FIG. 7** shows a sensor device 700 which can be seen as a variant of any of the sensor devices shown in FIG. 3A to FIG. 6, and more specifically as a special case of FIG. 6, wherein the diagnostic controller 722 comprises reverse functions, and wherein the position or angle or phase θ1 determined by the DSP 713 when working in the first mode during a first moment in time, based on sensor signals "ss" obtained from the sensors or transducers 710 is provided as a "known good" position or angle or phase θ1good to the Diagnostic Controller 722. The diagnostic controller 722 is configured for converting this assumed "known good" value θ1 into at least two digital test values "dtv", optionally taking into account an estimate of the amplitude of the sensor signals "ss". The same functions as described above (mainly in FIG. 6) can also be used here, e.g. a sine and a cosine function, or three 120° phase shifted sine functions, or four 90° phase shifted sine functions, optionally scaled, optionally with added noise, optionally with an added offset value (e.g. to emulate a constant disturbance field), optionally with different offset values (e.g. to emulate different offsets of the individual sensors), optionally with an inverse sensitivity correction (e.g. as described above, in FIG. 4A).

Referring back to FIG. 7, the sensor device 700 may be communicatively connected or connectable to an external processor 730 (e.g. an ECU), which may be configured to perform the consistency test, e.g. by comparing the value of θ1 (obtained from a real measurement), and the value θ2 derived from the digital test values "dtv". Or stated in simple terms, in the embodiment of FIG. 7, a first value θ1 is measured based on sensor signals "ss", and this value θ1 is looped back **at least once** in "diagnostics mode", resulting in a second output value θ2, which should be substantially equal to θ1.

In a further variant, the value of θ2 could again be considered as a "known good value", and be converted in digital test values "dtv", and re-inserted into the processing chain 723 by the MUX 718 configured in the second mode, resulting in a further value θ3, which should also be substantially equal to the value θ1 and θ2. In other words, in this embodiment, a first value θ1 is measured based on sensor signals "ss", and this value θ1 is looped back at least twice in "diagnostics mode", and the values θ1, θ2 and θ3 are provided to the external processor for error detection.

In another or a further variant, the value θ1 is received once by the Diagnostic Controller, is temporarily stored (e.g. in a data register or in RAM), and is sent multiple times (e.g. at least two times, or at least three times) to the DACs 717, but with different amplitudes, resulting in output values θ2a, θ2b, etc. The external processor 730 would be configured to perform a consistency-test between the values θ1 and θ2a, where θ2a is derived from a first set of digital test values "dtv1" derived from θ1 but scaled to have a first amplitude "A1", and to perform a consistency test between the values θ1 and θ2b, where θ2b is derived from a second set of digital test values "dtv2" derived from the same value θ1 but scaled to have a second amplitude "A2" different from "A1".

In another or a further variant (not explicitly shown) of FIG. 7, the sensor device 700 further comprises a second set of at least two input nodes connectable to a second set of sensors or transducers for receiving a second set of at least two sensor signals, also indicative of said position or phase to be measured (optionally offset by a predefined constant), and the multiplexer 718 is a three-way-multiplexer, and the DSP 713 is configured to selectively provide (e.g. depending on the routing mode of the multiplexer) a first measurement angle θ1, a test angle θ2, and a second measurement angle θ1aux; and the evaluation unit 731 may be further configured to perform a consistency test of the values θ1 and θ1aux, and/or to perform a consistency test of the values θ2 and θ1aux.

**FIG. 8** shows a sensor device 800 which can be seen as a variant of any of the sensor devices shown in FIG. 3A to FIG. 7, but in addition to the Diagnostic Controller (with or without Reverse Functions) 816, 822 and the set of digital-to-analog convertors DAC1 817, it has full redundancy of the sensors and of the signal processing path 823a, 823b.

More specifically, the sensor device 800 comprises: a second set of sensor or transducers 860, a second "forward data path" 823b comprising a second analog signal processor ASP2, 861 a second (or a second set of) analog-to-digital convertor(s) ADC2, 862 and a second digital signal processor DSP2, 863.

The "first forward signal path" 823a formed by ASP1, ADC1, DSP1 can be considered as a "main signal path", and the "second forward signal path" 823b formed by ASP2, ADC2, DSP2 can be considered as a "redundant signal path".

The sensor device 800 preferably comprises only a single semiconductor substrate comprising at least all the components of the "first signal path" 823a and the "second signal path" 823b, as well as the components MUX1 818, DAC1 817 and Diagnostic Controller1, and optionally also a communication unit 821, a non-volatile memory 820 and an Evaluation Unit 815. This semiconductor substrate may also comprise the first set of sensors 810 and optionally also the second set of sensors 860 embedded therein, but as described above, that is not absolute required, and it suffices that the first set of sensors 810 and the second set of sensors 860 are connectable to this semiconductor substrate via a first set of input nodes 819 and a second set of input nodes 869 respectively. The second set of sensors 860 may be of the same type or kind or construction as the first set of sensors 810, but that is not absolutely required, and in an embodiment, the second set of sensors 860 is of a different kind or type or construction than the first set of sensors 810. For example, the sensors 810 may comprise Hall elements, and the sensors 860 may comprise coils.

In an embodiment, the second set of input nodes 869 are electrically connected (e.g. hardwired) to the inputs of ASP2 861, and the sensor device 800 does not comprise any of the following optional components: a second diagnostic controller 866 or 872, a second set of DACs 867, a second MUX 868, a second communication unit 871, a second evaluation unit 865, a second non-volatile memory 870. In this embodiment, the first signal path (ASP1, ADC1, DSP1) can be operated in a first mode for processing sensor signals ss1 obtained from the first set of sensors 810 for providing a first value θ1, or in a second mode for processing analog test signals ats1 derived from digital test values dtv1 provided by DiagnosticController1 to the first set of DACs 817 for providing a second value θ2, whereas the second signal path 823b is only operated in the first mode for processing sensor signals ss2 obtained from the second set of sensors 860 to provide a third value θ3. (It is noted that the first or second mode of the second data path 823b can be considered a third or fourth mode of the sensor device 800).

In another embodiment, the sensor device 800 also comprises a second Diagnostic Controller with reverse functions 872 or without reverse functions 866, and comprises a second set of DACs 867, and comprises a second multiplexer 868, and each of the first and the second signal path 823a, 823b can be configured in a first mode for processing sensor signals ss1, ss2 respectively, and in a second mode for processing analog test signals ats1, ats2 respectively.

In yet another embodiment (not explicitly shown), MUX2, DACs2, and Diagnostic Controller2 are not present, but the first multiplexer MUX1 818 can be further configured in a third mode to route the set of analog test signals ats1 generated by the first set of DACs 817 based on digital test values dtv1 provided by the first Diagnostic Controller 816, 822 to the input of ASP2, for diagnosing the second signal path 823b.

In an embodiment, the first signal path 823a formed by ASP1, ADC1 and DSP1 and the second signal path 823b formed by ASP2, ADC2, DSP2 are homogeneous (e.g. are implemented using the exact same layout).

In an embodiment, the first signal path 823a formed by ASP1, ADC1 and DSP1 and the second signal path 823b formed by ASP2, ADC2, DSP2 are heterogeneous (e.g. are implemented using a different layout, and/or using different principles or a different algorithm).

Depending on where the consistency test is performed, e.g. inside the sensor device 800, or by an external processor 830 (e.g. ECU) connected to the sensor device 800, one or both of the evaluation units 815, 865 may be present or absent. This is described in more detail above, and illustrated in FIG. 4A to FIG. 7.

Depending on where the digital test values "dtv" come from (e.g. from a non-volatile memory, or from the external processor, or from the DSP) and in which form (e.g. as digital test values "dtv" that can be applied "as such" to the DACs, or as a position or angle or phase θ that needs to be converted into a set of digital test values before they can be applied to the DACs), a first and/or second diagnostic controller 816, 822, 866, 872 with or without reverse functions can be used, and/or a first and/or second communication unit 821, 871 may be absent or present, and/or a first/second non-volatile memory 820, 870 with digital test values may be absent or present. This is also described in more detail above, and illustrated in FIG. 4A to FIG. 7, but not all data paths of FIG. 4A to FIG. 6 are shown in FIG. 8, in order not to overload the drawings.

In a practical implementation, the sensor device 800 may be configured in a first mode of operation during a first period of time for measuring and processing signals ss1, ss2 obtained from the sensor elements 810 and 860 to θ1 and θ3, and may be configured in a second mode of operation during a second period of time for evaluating the circuit for diagnostic purposes. Various timing schemes can be used, for example, in an embodiment, a diagnostic test is performed after each sensor measurement. In another example, a diagnostic test is performed only once after two or more sensor measurements. It is also possible to use different sources, e.g. to use digital test values obtained from a non-volatile memory 820 in certain time slots, and to use digital test values obtained from an external processor 830 in other time slots, etc. The skilled reader having the benefit of the present disclosure can easily come up with other alternatives.

**FIG. 9** shows a sensor device 900 which can be seen as a variant of the sensor device 800 of FIG. 8, but having only a single diagnostic controller with or without reverse functions 922, 916, and optionally a single communication unit 921 and preferably a single non-volatile memory 920 (e.g. with a plurality of datasets, and/or containing at least one look-up table for performing a sine function and/or a phase shifted sine function).

In an embodiment, the first set of DACs 917 is present, but the second set of DACs 967 is not present. In an embodiment, the multiplexer MUX 918 is capable of routing either the first set of sensor signals ss1 or the first set of analog test signals "ats1" to the first analog processor ASP1, and of routing the second set of sensor signals ss2 to ASP2, but not capable of routing analog test signals "ats1" to the second analog processor ASP2. In another embodiment, the multiplexer 918 is capable of routing ss1 to ASP1 and ss2 to ASP2 in a first mode, and of routing the analog test signals ats1 to ASP1 in a second mode, and of routing the analog test signals ats2 to ASP2 in a third mode. The second and third mode may be implemented as a single mode, or as different modes. In yet another embodiment, the multiplexer 918 is capable of routing ss1 to ASP1 and ss2 to ASP2 in a first mode, and of routing the analog test signals ats1 to both ASP1 and ASP2 in a second mode.

In an embodiment, the first set of DACs 917 is present, as well as the second set of DACs 967. In this case the multiplexer MUX 918 may be configurable in a first mode for simultaneously routing ss1 to ASP1 and ss2 to ASP2, and configurable in a second mode for simultaneously routing ats1 from DACs1 to ASP1 and ats2 from DACs2 to ASP2. In this embodiment the first signal path 923a and the second signal path 923b may be simultaneously tested with different analog test signals ats1, ats2.

It is explicitly pointed out that all variations described above in FIG. 3A to FIG. 7 are also envisioned in the sensor device of FIG. 8 and FIG. 9, e.g. related to the number of digital test signals (e.g. 2x quadrature signals, 3x 120° phase shifted, 4x 90° phase shifted), and/or related to the origin and type of the digital test values (e.g. obtained from NV-memory, received from an external processor, obtained from DSP1), and/or related to modification of the digital test values (e.g. scaling, offset, inverse sensitivity correction, noise), and/or related to internal or external consistency check, and/or related to consistency check with predefined (fixed) validity boundaries, or with boundaries adapted dependent on the amplitude of the sensor signals "ss", etc.

**FIG. 10** shows a sensor device 1000 which can be seen as another variant of the sensor device 800 of FIG. 8, and/or as a variant of the sensor device 900 of FIG. 9, the main difference being that the first and the second DSP are combined in a single DSP 1090, e.g. in a single ASIL D compliant DSP, which can be implemented in less silicon area than two separate DSP's DSP1 and DSP2. The single DSP may offer the same functionality as the two discrete DSP's, but may have a footprint smaller than 190% of the footprint of DSP1 or DSP2, preferably smaller than 180%, or smaller than 170%, or smaller than 160%. Or stated in other words, the single DSP 1090 preferably has a footprint smaller than 95% of the combined footprint of DSP1 and DSP2, or smaller than 90% or smaller than 85% or smaller than 80%. The tasks originally performed by DSP1 may be implemented by a first software module residing at a first location in a non-volatile memory 1020 (comprising executable instructions), and the tasks originally performed by DSP2 may be implemented by a second software module residing at a second location in the non-volatile memory 1020, non-overlapping with the first location. The single DSP 1090 may be connected to two separate non-volatile memories (not shown).

It is explicitly pointed out that all variations described above in FIG. 3A to FIG. 9 are also envisioned in the sensor device of FIG. 10, e.g. related to the number of digital test signals (e.g. 2x quadrature signals, 3x 120° phase shifted, 4x 90° phase shifted), and/or related to the origin and type of the digital test values (e.g. obtained from NV-memory, received from an external processor, obtained from DSP1), and/or related to modification of the digital test values (e.g. scaling, offset, inverse sensitivity correction, noise), and/or related to internal or external consistency check, and/or related to consistency check with predefined (fixed) validity boundaries, or with boundaries adapted dependent on the amplitude of the sensor signals "ss", etc.

**FIG. 11** shows a sensor device 1100 which can be seen as a further variant of the sensor device of FIG. 10, wherein the single DSP 1190, e.g. ASIL D compliant DSP, also performs the Diagnostic function with or without the Reverse Functions (e.g. as a third software module), and optionally also performs the Consistency Test (e.g. as a fourth software module). The software modules of this DSP are preferably stored in a non-volatile memory, (e.g. Flash) but could also be stored in read-only-memory (ROM, not shown). The digital test data "dtv" (if present in the sensor device) may also be stored in this same non-volatile memory, or in another non-volatile memory (not shown). The sensor device 1100 may also comprise a communication unit (not explicitly shown in FIG. 11), e.g. for allowing the DSP 1190 to communicate with an external processor 1130, e.g. via a communication bus 1133. The communication unit is not explicitly shown, instead possible outputs of the various software modules are schematically connected via arrows to a communication link with the external processor. The main purpose of FIG. 11 is to illustrate that the sensor device 1100 may comprise ASP1, ADC1, ASP2, ADC2, DACs1, MUX and a single DSP (optionally ASIL D compliant) as its main components, preferably implemented on a single semiconductor die. Similar as mentioned above, the first set of sensors 1110 and the second set of sensors 1160 may also be implemented in this semiconductor die, but that is not absolutely required, and they can also be implemented on one or more further semiconductor die(s) incorporated in the same packaged semiconductor device ("chip"), or as conductive tracks (e.g. copper tracks) on a printed circuit board (PCB).

In a variant (not shown) of FIG. 11, there is only one DAC 1117 (not 1167), and there is only one forward data path 1123a (not 1123b), and the software does not contain "software2". This variant can provide θ1 and θ2, but cannot provide θ3 and θ4. This variant is very similar to FIG. 3C with an asil-D compliant DSP.

**FIG. 12** shows a flow-chart of a method 1200 of detecting an error of a sensor device as described above, e.g. any of the sensor devices illustrated in FIG. 3A to FIG. 11. The method comprises the following steps:
a) generating in step 1201 a plurality (N ≥2) of at least two analog test signals (ats), related to a test vector having known digital test values (dtv) or derived from a known position or phase value (θgood);
b) routing in step 1202 the plurality of at least two analog test signals (ats) to a forward signal path that comprises: an analog circuit (ASP) having at least one amplifier, followed by a digitizer circuit having at least one analog-to-digital convertor for generating at least two digital values (dv), followed by a digital processing circuit (DSP);
c) optionally calculating in step 1203 by the digital processing circuit a phase or position value (e.g. θ2) based on the at least two digital values (dv) provided by the digitizer circuit;
d) detecting in step 1204 an error by performing a consistency test based on a comparison of the at least two digital values (dv) and/or of the position or phase (θ2) determined by the DSP on the one hand, and the known digital test values (dtv) and/or the known position or phase (θgood) on the other hand.

Many variants of this method are contemplated, e.g. as described in functional terms above, when discussing FIG. 3A to FIG. 11, for example:
Step a) may refer to the mere digital-to-analog version of digital values obtained from a non-volatile memory;
Step a) may further comprise the processing of the digital values obtained from memory, or obtained from DSP1, or obtained from an external processor, as may be performed by the Diagnostic Controller (e.g. one or more of: scaling, adding offset, temperature based inverse sensitivity correction, adding noise, etc.);
Step a) may also comprise the conversion of a phase value into a sine and cosine value, or into three 120° phase shifted sine values, or into four 90° phase shifted sine values;
Step b) may comprise: configuring a multiplexer or switches or tri-state buffers in a second mode;
Step c) may optionally comprise converting three 120° phase shifted signals into two quadrature signals (e.g. using a Clarke transformation), or converting four 90° phase shifted signals into two difference signals (e.g. by pairwise subtraction);
Step c) may comprise applying a non-linear function to the ratio, e.g. implemented by a look-up table with interpolation.
Step c) may comprise first determining an arctangent of the ratio, and subsequently applying a customer dependent scaling and/or a customer dependent offset on the resulting angle. The customer dependent scaling value and/or offset value may be determined during a calibration test, and may be stored in a non-volatile memory.
Step d) may comprise: determining a difference between the position θ2 derived from the test values, and the known good position value, and testing if this difference lies in a valid region, or testing if an absolute value of this difference is smaller than a threshold value. The consistency test may use (a) predefined valid region or (a) predefined threshold value(s), or may use boundaries or a threshold value which are dependent on an amplitude of the sensor signals of a previous measurement, or dependent on a sensor configuration (e.g. a readout-scheme, a configurable series-connection of multiple sensors, etc.).

**FIG. 13A** shows a sensor device 1300, which can be seen as a variant of the sensor device 350 of FIG. 3C with the addition of an evaluation unit 1315 (if implemented inside the sensor device 1300), and with the addition of a diagnostic controller 1325 with reverse function (as in FIG. 6), capable of converting a (considered "known good") angle or phase θgood3 from an external processor (not shown), and/or which can also be seen as a variant of the sensor device 600 of FIG. 6 with the addition of a second set of sensors and a second set of input nodes, and with a 3-way multiplexer, in which the evaluation unit 615 and the communication unit 621 are present.

This sensor device is capable of determining a first (or main) angle or phase θ1 when the multiplexer 1318 is configured in a first routing mode in which the first set of sensor signals ss1 obtained from the first (or main) sensor set 1310 is applied to the single forward signal path 1323, and is capable of determining a test angle or phase θ2 when the multiplexer 1318 is configured in a second routing mode in which the set of analog test signals "ats" derived from digital test values "dtv" is applied to the forward signal path 1323, and is capable of determining an auxiliary angle or phase θ1aux when the multiplexer 1318 is configured in a third routing mode in which the second set of sensor signals ss2 obtained from the second (or auxiliary or redundant) sensor set 1360 is applied to the single forward signal path 1323.

In the example shown in FIG. 13A, the ASP block and the ADC block are shown as a single block for illustrative purposes only. The ASP block may also be referred to as "analog front end" block. This block may include "sensitivity correction related to a varying temperature". The block 1326 may comprise one or more DACs, and may optionally further comprise an "inverse sensitivity correction", but the latter is not absolutely required. In fact, as explained above, the "inverse sensitivity correction" may be implemented in the block 1325 instead, or may be omitted. The block 1325 may be referred to as "diagnostic controller with reverse function" or as "inverse DSP". As an example, if the DSP 1313 is configured to calculate an arctangent function of a ratio of the two digital values "dv", the block 1325 may be configured to apply a sine and a cosine to the angle θgood3, and optionally to scale this sine and cosine value.

In the specific example shown in FIG. 13A, the DSP 1313 has two separate output ports: a first port providing only measurement results θ1 derived from the first set of sensors 1310; and a second port providing values θ1 at first moments in time, values of θ2 at second moments of time, and values of θ1aux at third moments of time. Typically the sensor device 1300 will provide measurement values of θ1 periodically (e.g. to an external device), but the consistency test does not have to be performed at the same rate.

In a variant of FIG. 13A, the evaluation unit 1331 is situated outside of the sensor device, e.g. in an external processor (not explicitly shown in FIG. 13), but see e.g. FIG. 6. In this case, the sensor device 1300 may further comprise a communication unit (not explicitly shown in FIG. 13A).

Everything else mentioned above for FIG. 3C and/or FIG. 6 is also applicable here, mutatis mutandis. For example, the blocks 1313 and 1325, and optionally also the block 1315 may be implemented in a single programmable processor, preferably an ASIL-D compliant processor.

**FIG. 13B** shows a sensor device 1350 which is a variant of the sensor device 1300 of FIG. 13A, the main difference being that the angle applied to the diagnostic controller (or "inverse DSP") 1325 is a copy of a previously measured angle or phase θ1, referred to above as "loop-back".

In another or further variant of FIG. 13A and FIG. 13B, the test-angle θgood provided to the diagnostic controller 1325 can be dynamically selected from (i) a value provided by an external processor (as in FIG. 13A), or (ii) a previous measurement calculated by the DSP 1313, or (iii) a value obtained from a non-volatile memory (not explicitly shown), e.g. in a manner similar as explained in FIG. 6 with θgood1, θgood2, θgood3.

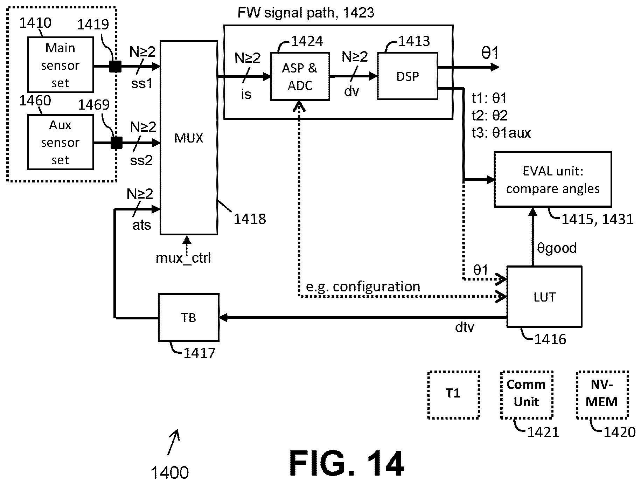

**FIG. 14** shows a sensor device 1400 which can be seen as a simple variant of the sensor device 1300 of FIG. 13A or of FIG. 13B. The main difference being that (1) instead of using high-resolution digital-to-analog convertors, the DACs 1417 used in the embodiment of FIG. 14 have a relatively low resolution, e.g. at most 5 bits, or at most 4 bits, or at most 3 bits (see for example FIG. 18); and (2) the diagnostic controller 1416 does not contain an inverse function (i.e. is not capable of converting an angle into digital test values), but is based on a processing block comprising a simple lookup-table (LUT) comprising a small list of predefined sets of test-values, each set comprising for example an angle (provided to the evaluation unit), and a 3 to 5-bit sine value, and a 3 to 5-bit cosine value, without scaling, without offset, without added noise, without temperature correction, etc. The values of the look-up table may be stored in a (small) non-volatile memory, or may be hardcoded.

The main advantages of this embodiment are: (i) that the DAC circuit 1417 can be very simple and require a very small footprint, and (ii) that the diagnostic controller 1416 is also very simple and does not require much evaluation time, and (iii) this embodiment still allows to test the full signal chain (including the multiplexer, ASP, ADC and DSP), albeit with a small number of predefined angle values.

It is noted that the Lookup-table may contain some signal chain configurations, such as e.g. gain setting, as suggested by the dotted line.

The calculated phase or angle θ1 may be applied to the LUT 1416, which may select values for "dtv" corresponding to an angle that is close to θ1.

As mentioned above, the DSP 1413, the evaluation unit 1415 and the "diagnostic controller" 1416 are preferably implemented in a single programmable processor.

In a variant of FIG. 14, the consistency test is not performed inside the sensor device 1400 itself, but is performed by an external processor, e.g. in a manner similar as shown in FIG. 6.

In another or a further variant of FIG. 14, the sensor device may further comprise one or more of the following: a communication unit, a non-volatile memory, a temperature sensor.

It is noted that the diagnostic controller of FIG. 14 may not explicitly include "scaling", but may be configured to select certain (e.g. relatively small) values from the look-up table to obtain the same or a similar effect. In other words, the selection of digital test values may be based on a gain setting of the ASP block.

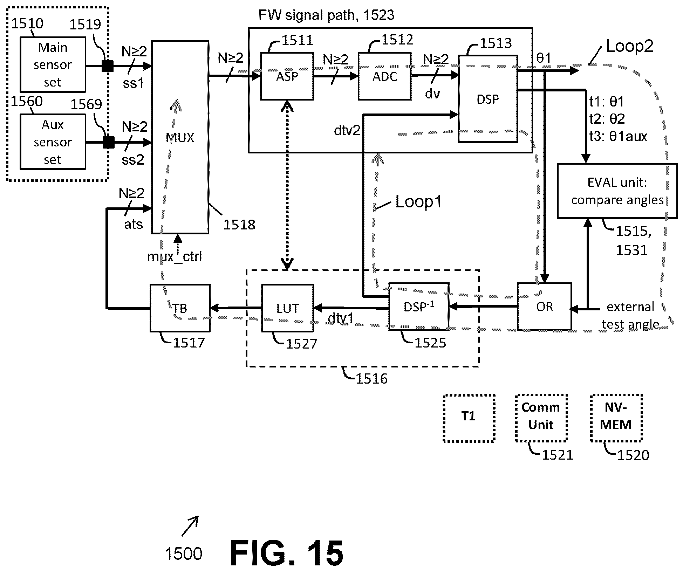

**FIG. 15** shows a sensor device 1500 which can be seen as a variant of FIG. 3C, with a simpler DAC 1517 (e.g. having a resolution of at most 3, or at most 4 or at most 5 bits); and with the addition of an evaluation unit 1515; and with a somewhat more complex diagnostic controller 1516 including both an inverse function (e.g. capable of calculating a sine and a cosine value of a known, good angle, and having a lookup-table 1527), and wherein the DSP 1513 is further configured to receive a set of at least two digital test values dtv2 from the diagnostic controller 1516; and wherein the evaluation unit 1515 is configured to detect an error of the DSP by testing a consistency of a first loop (Loop1) including the DSP and at least a portion of the diagnostic controller 1516 in a first test mode, and wherein the evaluation unit 1515 is further configured to detect an error of the forward signal path 1523 by testing a consistency of a second loop (Loop2) that includes the forward signal path 1523 in a second test mode.

The sensor device 1500 can also be seen as a variant of the sensor device 1300 of FIG. 13A or of FIG. 13B, or as a further variant of the sensor device 1400 of FIG. 14.

An important advantage of the sensor device 1500 is that the DSP 1513 can be tested in a different way (e.g. at a higher resolution and/or at a different speed and/or more often or less often) than the rest of the forward signal path 1523.

Other variations described above, may also be applicable here, mutatis mutandis. For example, the evaluation unit 1531 may be located outside of the sensor device (e.g. implemented in an ECU communicatively connected to the sensor device 1500); the sensor device 1500 may further comprise one or more of the following: a communication unit 1521, a non-volatile memory 1520, a temperature sensor, etc.

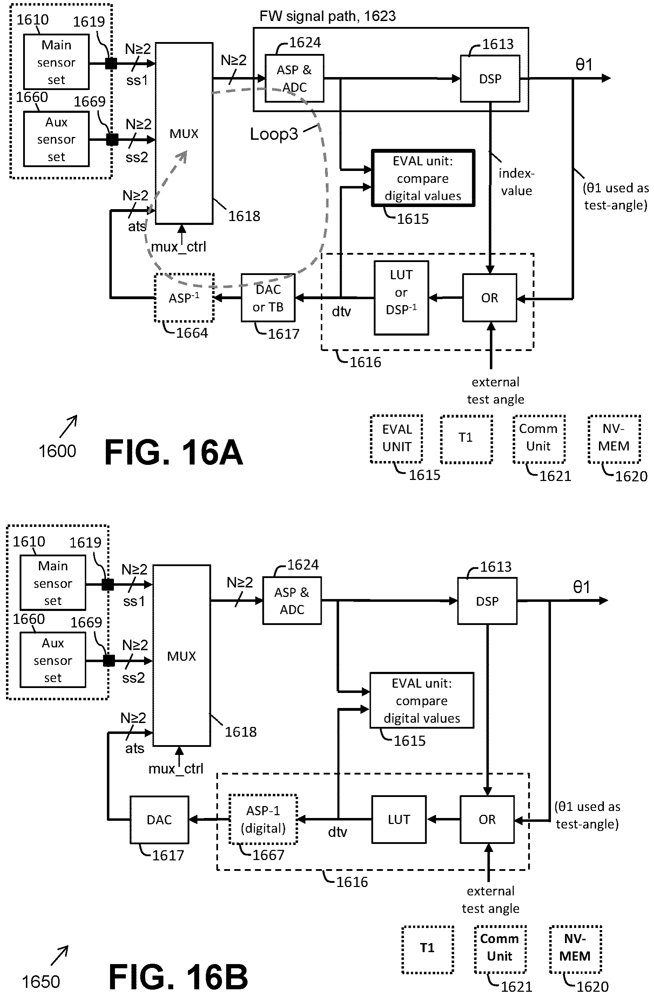

**FIG. 16A** shows a sensor device 1600 which can be seen as yet another variant of FIG. 3C, with several modifications, the most important modification being that this sensor device comprises an evaluation unit 1615 which is configured to test a consistency of the values applied at the input to the DSP 1613 and the digital test values "dtv", or in other words, wherein the evaluation unit 1615 is configured to detect an error of a portion 1624 of the forward data path including the ASP and the ADC by testing a consistency of a third loop (Loop3). It is explicitly pointed out that this feature (referred to herein as "test-loop3") may be added to all other embodiments of the present invention, for example to the sensor device of FIG. 15, which would then be able to more accurately locate an error.

It is noted that FIG. 16A also shows an optional block 1664 located between the DACs 1617 and the MUX 1618. This block may for example apply an "inverse temperature correction" to the signals generated by the DACs 1617 to counteract a "sensitivity correction" that may be present in the ASP block.

In a variant of FIG. 16A, the sensor device 1600 further comprises an evaluation unit 1615, e.g. arranged in a similar manner as illustrated in FIG. 15A, and capable of detecting an error in the (entire) forward signal path 1623, e.g. by comparing the angle θ1 calculated by the DSP 1613 with a known good angle (e.g. obtained from a non-volatile memory, or obtained from an external processor, e.g. in a similar manner as described above).

As suggested by the label "DAC or TB", the digital-to-analog-convertor circuit 1617 may be a circuit with a high resolution (e.g. at least 8 bits, or at least 10 bits), or may be circuit with a low resolution (e.g. at most 5, or at most 4 or at most 3 bits).

As suggested by the label "LUT or DSP-1", the diagnostic controller 1616 may be a very simple circuit capable of providing digital test values from a look-up table based on an index provided by the DSP; or may be a relatively complex diagnostic controller 1616 with reverse functions (e.g. with a sine and a cosine function, optional scaling, optional sign inversion, etc.) capable of converting an angle or phase value into a set of at least two digital test values "dtv".

Other variations described above, may also be applicable here, mutatis mutandis. For example, the sensor device may further comprise one or more of the following: a communication unit 1521, a non-volatile memory 1520, a temperature sensor, etc.

In another or a further embodiment, the sensor device 1600 may be configured for routing the first set of sensor signals (ss1) to the analog circuit 1624 in a first mode of operation, and the evaluation unit 1615 may be configured for temporarily storing the resulting set of digital values dv1, and the sensor device 1600 may be configured for routing the second set of sensor signals (ss2) to the analog circuit 1624 in a second mode of operation, and the evaluation unit 1615 may be configured for temporarily storing the resulting set of digital values dv2, and the evaluation unit 1615 may be configured for testing a consistency between the set of values dv1 and the set of values dv2, e.g. by determining a first ratio (e.g. R1) of the set of values of dv1 (e.g. a ratio of the sine and cosine value), and by determining a second ratio (e.g. R2) of the set of values of dv2 (e.g. a ratio of the sine and cosine value), and by determining a consistency between the first ratio R1 and the second ratio R2. In an example, the sensor elements of the first set of sensors and the sensor elements of the second set of sensors are located at substantially the same location. In this case, the ratio R1 and R2 should be approximately the same. In another example, the sensor elements of the first set of sensors and the sensor elements of the second set of sensors are angularly shifted relative to one another, by a predefined angular offset. In this case the value of R1 and R2 are typically not the same, but there is a one-to-one correspondence between them, which can be stored in a lookup-table stored in a non-volatile memory (e.g. in the same non-volatile memory as mentioned above, or in another non-volatile memory). The consistency test may be based on this look-up table.

**FIG. 16B** shows a sensor device 1650 which can be seen as a variant of FIG. 16A, having an optional block 1667 configured to perform the same task as block 1664 of FIG. 16A, for example sensitivity correction, but implemented in the digital domain. Everything else described above for FIG. 16A is also applicable here.

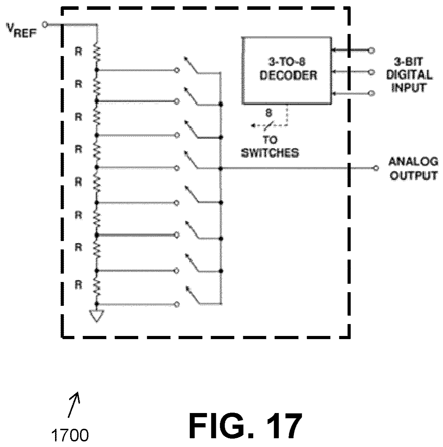

**FIG. 17** shows an example of a very simple circuit, known in the art as a "Kelvin devider" or "string DAC", that can be used in embodiments of the present invention as a low-resolution digital-to-analog-convertor, for example in FIG. 14 to FIG. 16B, and may be labelled as "TB". As can be appreciated, this circuit comprises a series connection of 8 resistors, and comprises 8 switches, one of which is closed by means of a 3-to-8 decoder. This circuit is capable of providing one out of eight analog signals, generated as a fraction of a reference voltage VREF. FIG. 17 is provided for completeness only, as an illustration that even a very simple circuit can be used as a "digital-to-analog convertor circuit", but of course, the present invention is not limited to this particular circuit, and many other circuits may also be used, e.g. a circuit comprising a PWM block with a programmable duty-cycle, followed by a low-pass filter.

Finally, while individual features are explained in different drawings and in different embodiments of the present invention, it is contemplated that features of different embodiments can be combined, as would be obvious to the skilled person, when reading this document. For example, in all the block-diagrams, the sensor device may comprise a temperature sensor and/or a non-volatile memory storing predefined values, but this is not explicitly shown in all embodiments, in order not to overload the drawings. As another example, in all embodiments of the present invention, the DSP may be an ASIL-D compliant DSP.

It is also pointed out that in some embodiments (see e.g. FIG. 3A) the DSP is shown to have only one output port capable of providing the measured values θ1 (derived from the sensor signals), and the test values θ2 (derived from the digital test values) in a time-multiplexed manner, embodiments of the present invention are not limited hereto, and in variants of the schematics shown, the DSP has two dedicated output ports, including a first output port for providing only the measured values θ1, and a second output port for providing only the test values θ2. In yet another variant, the DSP has two output ports, including a first output port for providing only the measured values θ1 (e.g. to an external device), and a second output port for providing both the measured values θ1 and the test values θ2, e.g. in an interleaved manner, e.g. to an evaluation unit. It is of course also possible that the DSP has three output ports, for example a first output port for providing only values θ1 derived from the sensor signals, a second output port for providing only values θ2 derived from the test signals, and a third output port for providing both θ1 and θ2 values in an interleaved manner.

### REFERENCE NUMBERS modulo 100:

| | | | |
|---|---|---|---|
| -00 | sensor device | -10 | (first) set of sensors or transducers |
| -11 | Analog Signal Processing circuit (ASP) | -12 | Analog-to-Digital Conversion circuit (ADC) |
| -13 | Digital Signal Processor (DSP) | -14 | (first) semiconductor substrate |
| -15 | evaluation unit | -16 | diagnostic controller |
| -17 | Digital-to-Analog Conversion circuit (DAC) | -18 | MUX |
| -19 | input nodes | -20 | NV-memory |
| -21 | communication unit or communication interface | | |
| -22 | diagnostic controller with reverse functions | | |
| -23 | forward data path (comprising ASP, ADC, DSP) | | |
| -24 | Analog Signal Processing and Digitization | -25 | Inverse DSP (DsP⁻¹) |
| -26 | DAC and inverse ASP (DAC & ASP⁻¹) | -27 | Look-Up Table |
| -30 | external processor (e.g. ECU) | -31 | evaluation unit of external processor |
| -31 | non-volatile memory embedded in, or connected to external processor | | |
| -32 | NV-memory | -33 | external bus |
| -50 | sensor device | -60 | second set of sensors |
| -61 | ASP2 | -62 | ADC2 |
| -63 | DSP2 | -64 | analog ASP⁻¹ (or inverse ASP) |
| -65 | evaluation unit | -66 | diagnostic controller2 |
| -67 | digital ASP⁻¹ (or inverse ASP) | -68 | second multiplexor (MUX2) |
| -69 | second set of input nodes | -70 | second NV-memory |
| -71 | second communication unit or communication interface | | |
| -72 | second diagnostic controller with reverse functions | | |
| -90 | ASIL D compliant DSP | | |

### OTHER:

| | | | |
|---|---|---|---|
| dtv | digital test value(s) | ats | analog test signals |
| ss | sensor signals | is | input signals (at input of ASP) |
| as | amplified signals (at output of ASP) | dv | digital values (at output of ADC) |

## Claims

1. A sensor device (300; 400; 500; 600; 700; 800; 900; 1000; 1100; 1300; 1350; 1400; 1500; 1600; 1650) comprising:
- a first set of at least two input nodes (319) connectable to a first set of at least two sensors (310) for receiving a first set of at least two sensor signals (ss1) indicative of a position or a phase (θ1) to be measured;
- a first forward signal path (323) comprising:
- an analog circuit (311) comprising at least one amplifier configured for amplifying a set of at least two analog signals or signals derived therefrom and for providing a set of at least two amplified signals (as);
- a digitizer circuit (312) configured for digitizing the set of at least two amplified signals (as), and for providing a set of at least two digital values (dv);
- a digital processing circuit (313) configured for determining a position or phase (θ1) based on the set of at least two digital values (dv);
- a test signal generation circuit (316,317) for generating a set of at least two analog test signals (ats);
- a routing circuit (318) for selectively routing the first set of sensor signals (ss1) from the first set of input nodes (319) to the analog circuit (311) in a first routing mode, and for selectively routing the set of analog test signals (ats) obtained from the test signal generation circuit to the analog circuit (311) in a second routing mode;
- wherein the sensor device (300) is configurable in a first mode of operation wherein the routing circuit (318) is configured in the first routing mode, and the digital processing circuit (313) is configured to determine said position or phase (θ1) based on the first set of sensor signals (ss1); and
- wherein the sensor device is configurable in a second mode of operation wherein the routing circuit (318) is configured in the second routing mode, and the digital processing circuit (313) is configured to analyse and/or verify the set of digital values (dv) derived from the set of analog test signals (ats) and/or to determine a test position or test phase (θ2) derived from the set of analog test signals (ats).

2. A sensor device according to claim **1,** wherein the test signal generation circuit (316, 317) comprises:
- a digital-to-analog conversion circuit (317; 417; 517; 617; 717; 1417; 1517; 1617) for converting a set of at least two digital test values (dtv) into a set of at least two analog test signals (ats);
- and a diagnostic controller (316; 416; 516; 622; 722; 1416; 1516; 1616) configured for providing at least two digital test values (dtv) to the digital-to-analog conversion circuit.

3. A sensor device according to any of the previous claims,
wherein the test signal generation circuit (316,317) is configured for providing the set of at least two analog test signals (ats)
- based on a position value or phase value (θgood1) provided by the digital processing circuit (313) as the result of a previous evaluation; or
- based on a position value or phase value (θgood2) retrieved from a non-volatile memory (420; 532; 620; 630; 820; 920; 1020); or
- based on a position value or phase value (θgood3) obtained from an external processor (530; 630; 730).

4. A sensor device (300) according to any of the previous claims,
wherein the test signal generation circuit is configured for receiving or retrieving an angle value or a phase value;
and generating the set of at least two analog test signals comprises converting this received or retrieved angle or phase value into one of the following sets of values:
a) into at least a sine value and a cosine value of that angle; or
b) into at least three 120° phase shifted sine values of that angle.

5. A sensor device (300) according to any of the previous claims,
wherein the first set of sensors (310) is configured for providing two sinusoidal signals having substantially the same amplitude but substantially 90° phase shifted, and wherein the diagnostic controller (316) is configured for providing a set of two digital test values (dtv) corresponding to a sine and a cosine value of a certain phase;
or wherein the first set of sensors (310) is configured for providing three sinusoidal signals having substantially the same amplitude but substantially 120° phase shifted, and wherein the diagnostic controller (316) is configured for providing a set of three digital test values (dtv) corresponding to three sine values of a certain phase, shifted by multiples of 120°;
or wherein the first set of sensors (310) is configured for providing four sinusoidal signals having substantially the same amplitude but substantially 90° phase shifted, and wherein the diagnostic controller (316) is configured for providing a set of four digital test values, corresponding to four sine values of a certain phase, shifted by multiples of 90°.

6. A sensor device (500; 600; 700; 800; 900; 1000; 1100; 1300; 1350; 1400; 1500; 1550) according to any of the previous claims,
wherein the sensor device (500) or an external controller (530) connected to the sensor device is configured for detecting an error by performing a consistency test between the second position or phase (θ2) provided by the forward data path (323) operating in the second mode based on the at least two analog test signals (ats) provided by the digital-to-analog conversion circuit (517) and a corresponding known position or phase (θgood).

7. A sensor device (400) according to any of the previous claims,
wherein the sensor device (400) comprises a non-volatile memory (420) storing at least one set of digital values (test_data), each set comprising a known position or phase (θgood) and at least two digital values corresponding to that test position or test phase (θgood);
and wherein the sensor device (400) further comprises an evaluation unit (415) configured for testing a consistency between test position or test phase value (θ2) derived from the at least two digital test values in the second mode of operation, and the corresponding known test position or phase (θgood) obtained from the non-volatile memory (420).

8. A sensor device (500) according to any of the previous claims,
wherein the sensor device (500) further comprises a communication unit (521) configured to receive information from which said at least two digital test values (dtv) to be applied to the DAC-circuit (517) can be derived;
and wherein the sensor device (500) is configured for outputting the test position or test value (θ2) derived from the at least two digital test values (dtv) in the second mode of operation.

9. A sensor device (300; 800; 900; 1000; 1100; 1300; 1350; 1400; 1500; 1600; 1650) according to any of the previous claims,
wherein the sensor device is configured to produce the position or phase of the movable object uniquely based on said at least two digital values provided by the digitizer circuit (312) of the first forward signal path (323); and/or
wherein, in the second mode of operation, the routing circuit (318) is further configured to entirely disconnect said first set of at least two input nodes.

10. A sensor device (300; 800; 900; 1000; 1100; 1300; 1350; 1400; 1500; 1600; 1650) according to any of the previous claims,
wherein the sensor device further comprises a second set of at least two nodes (869; 969; 1069; 1169; 1369; 1469; 1569; 1669) connectable to a second set of sensors (860; 960; 1060; 1160; 1360; 1460; 1560; 1660) for receiving a second set of at least two sensor signals (ss2) indicative of said position or phase to be measured;
and wherein the routing circuit (318'; 818; 918; 1018; 1118; 1318; 1418; 1518; 1618) is further configured for selectively routing the second set of sensor signals (ss2) from the second set of input nodes (369; 869; 969; 1069; 1169; 1369; 1469; 1569; 1669) to the analog circuit (311) of the first forward signal path (323) in a third routing mode;
and wherein the sensor device is further configurable in a third mode of operation wherein the routing circuit is configured in the third routing mode, and the digital processing circuit (313) is configured to analyse and/or verify the set of digital values (dv) derived from the second set of sensor signals (ss2) and/or to determine an auxiliary position or an auxiliary phase (θ1aux) derived from the second set of sensor signals (ss2).

11. A sensor device (800; 900; 1000;1100) according to claim 10,
wherein, in the second and/or third mode of operation, the sensor device is further configurable:
i) to perform a consistency test based on said set of digital values (dv) and/or based on said test position or test phase (θgood) and/or based on said auxiliary position or auxiliary phase (θ1aux), e.g. for allowing error detection;
and/or
ii) to output said set of digital values (dv) and/or said test position or test phase (θgood) and/or said auxiliary position or auxiliary phase (θ1aux) for allowing an external processor to perform a consistency test, e.g. for error detection and/or error correction.

12. A sensor device (800; 900; 1000;1100;) according to any of the claims 1 to 9,
wherein the sensor device further comprises:
- a second set of at least two nodes (869) connectable to a second set of at least two sensors (860) for receiving a second set of at least two sensor signals (ss2) indicative of said position or phase to be measured;
- a second forward signal path (823b) comprising:
- a second analog circuit (ASP2) comprising at least one amplifier configured for amplifying the two second sensor signals (ss2) or signals derived therefrom;
- a second digitizer circuit (ADC2) for digitizing the amplified second sensor signals, and for providing at least two second digital values (dv2);
- a second digital processing circuit (DSP2) configured for determining a third position or phase (θ3) based on said at least two (first) digital signals (dv2).

13. A sensor device (800; 900; 1000; 1100;) according to claim 12,
- wherein the sensor device (800) further comprises a second digital-to-analog conversion circuit (867) for generating a second set of at least two analog test signals (ats2);
- wherein the sensor device (800) further comprises a second diagnostic controller (866, 872), or wherein the first diagnostic controller (816, 822) is further configured for providing at least two digital test values (dtv2) to the second digital-to-analog conversion circuit (867);
- wherein the sensor device (800) further comprises a second routing circuit (MUX2, 868), or wherein the first routing circuit (MUX1, 818) is further configurable for selectively routing the second sensor signals (ss2) from the second set of nodes (869) to the second analog circuit (ASP2, 861), and for routing the second analog test signals (ats2) from the second digital-to-analog conversion circuit (DAC2, 867) to the second analog circuit (ASP2, 861);
- wherein the sensor device (800) is configurable in a third mode of operation for determining a position or a phase (θ3) by routing the second sensor signals (ss2) to the second analog circuit (ASP2, 861); and
- wherein the sensor device (800) is configurable in a fourth mode of operation for determining a second test position or a second test phase (θ4) by routing the second analog test signals (ats2) to the second analog circuit (ASP2, 861);
and/or wherein the first digital processor (DSP1) and the second digital processor (DSP2) are implemented on a single digital signal processor (DSP);
and/or wherein the first DSP (DSP1) is an ASIL-D compliant DSP.

14. A sensor system comprising:
a sensor device according to any of the previous claims, wherein the at least two sensors are magnetic sensors for measuring a magnetic field, and wherein the system further comprises a magnetic source for generating said magnetic field, wherein the magnetic source is movable relative to the sensor device; wherein the sensor device is configured for determining a linear or an angular position of the magnetic source relative to the sensor device; or
a sensor device according to any of the previous claims, wherein the at least two sensors are magnetic sensors, and wherein the system further comprises a printed circuit board comprising said sensor device and comprising at least one transmitter coil for generating an alternating magnetic field; and wherein the system further comprises a conductive target which is movable (e.g. rotatable) relative to the printed circuit board and is configured to influence said alternating magnetic field; wherein the sensor device is configured for determining a linear or an angular position of the movable target relative to the sensor device.

15. A sensor system according to claim 14,
further comprising an external processor (530) connected to the sensor device (500; 600; 700; 800; 900; 1000; 1100);
wherein the external processor (530) is configured for one or more of the following:
a) for providing a digital test angle (θgood3) or at least two digital test values (test_data) to the sensor device to perform a diagnostic test, and for receiving a digital position or phase value (θ2), and wherein the external processor (530) is configured for performing a consistency test between the digital test angle (θgood3) or the at least two digital test values (test_data) and the diagnostic position or phase (θ2);
b) for receiving a measurement angle (θ1) derived from sensor signals (ss1) obtained from the first set of sensors (610), and for receiving a diagnostic angle (θ2) derived from analog test signals (ats) derived from digital test values (dtv) provided by a diagnostic controller (622), in turn derived from the measurement angle (θ1) by applying a reverse function, and wherein the external processor (630) is configured for performing a consistency test between the measurement position or phase (θ1) and the diagnostic position or phase (θ2).

16. A method (1200) of detecting an error of a sensor device according to any of the claims 1 to 13, or of a sensor system according to claim 14 or 15, the method comprising the steps of:
a) generating (1201) a plurality (N) of at least two analog test signals (ats) related to a test vector having known digital test values (dtv) or derived from a known position or phase value (θgood);
b) routing (1202) the plurality of at least two analog test signals (ats) to the first forward signal path (323) comprising: an analog circuit (ASP, 311) having at least one amplifier, followed by a digitizer circuit (322) having at least one analog-to-digital convertor for generating a set of at least two digital values (dv), followed by a digital-signal-processor (DSP, 323);
c) optionally calculating (1203) by the digital processing circuit (313) a position value or a phase value (θ2) based on the set of at least two digital values (dv) provided by the digitizer circuit (312);
d) detecting an error (1204) by performing a consistency test based on a comparison of the at least two digital values (dv) and/or of the position or phase (θ2) determined by the DSP on the one hand, and the known digital test values (dtv) and/or the known position or phase (θgood) on the other hand.
